# EUROPEAN PATENT SPECIFICATION

(11) **EP 4 227 667 B1**
(45) Date of publication and mention of the grant of the patent: **23.10.2024**
(21) Application number: 22156164.0
(22) Date of filing: 10.02.2022
(51) Int. Cl.: G01N 21/3504, G01N 21/3577, G01N 21/552

(54) **MONOLITHIC FLUID SENSOR SYSTEM AND METHOD FOR MANUFACTURING THE MONOLITHIC FLUID SENSOR SYSTEM**
MONOLITHISCHES FLUIDSENSORSYSTEM UND VERFAHREN ZUR HERSTELLUNG DES MONOLITHISCHEN FLUIDSENSORSYSTEMS
SYSTÈME DE CAPTEUR DE FLUIDE MONOLITHIQUE ET PROCÉDÉ DE FABRICATION DU SYSTÈME DE CAPTEUR DE FLUIDE MONOLITHIQUE

(43) Date of publication of application: 16.08.2023
(73) Proprietor: Infineon Technologies AG, 85579 Neubiberg (DE)
(72) Inventor: KOVATSCH, Christoph, 9584 Finkenstein (AT); STOCKER, Gerald, 9584 Finkenstein (AT); OSTERMANN, Thomas, 9231 Velden am Wörthersee (AT); GRILLE, Thomas, 9611 Nötsch (AT); BARTL, Ulf, 9500 Villach (AT); ASCHAUER, Elmar, 9581 Ledenitzen (AT)
(74) Representative: Hersina, Günter

(56) References cited:
- EP-A1- 3 705 872
- EP-A1- 3 715 829
- WO-A1-2014/032793
- WO-A1-2018/141070
- US-A1- 2021 088 440

## Description

### Technical Field

Embodiments relate in general to the field of sensor systems and methods for manufacturing sensor systems and, more specifically, to the field of monolithic fluid sensor systems (fluid = gas or liquid) and methods for manufacturing monolithic fluid sensor systems. In particular, embodiments relate to a fusion-bond or wafer-bond based wafer-level package for a mid-infrared gas sensor system.

### Background

The detection of environmental parameters in the ambient atmosphere is becoming increasingly important in the implementation of appropriate sensor systems, for example within mobile devices, but also in the implementation in home automation, such as smart home, and, for example, in the automotive sector. However, with the ever more extensive use of sensor systems, there is also a particular need to be able to produce such sensor systems as inexpensively as possible and, thus, as cost effectively as possible. However, the resulting reliability and accuracy of the sensor systems should nevertheless be maintained or should be even increased.

In particular, the field of monitoring the air quality and/or the gas composition in our environment is receiving more and more attention. However, typical gas sensors are rather expensive to manufacture and/or rather bulky.

EP 3 705 872 A1 relates to a gas sensor. The gas sensor comprises a substrate having a cavity for providing an optical interaction path for an interaction of a filtered IR (IR = infrared) radiation with a target gas in the cavity; a thermal emitter arranged for emitting a broadband IR radiation, wherein the thermal emitter is optically coupled to the cavity; a wavelength selective structure arranged for filtering the broadband IR radiation emitted by the thermal emitter; an IR detector arranged to provide a detector output signal based on a signal strength of the filtered IR radiation having traversed the optical interaction path in the cavity and being received by the IR detector.

WO 2018/141070 A1 relates to a biosensor chip combining surface plasmon and electrochemical detection. The biosensor comprises a waveguide configured to receive an optical radiation, and to propagate the optical radiation along the length of the waveguide as a surface plasmon-polariton (SPP) wave with its transverse electric field substantially perpendicular to the width of the waveguide, and to emit the propagated optical radiation away from the waveguide and towards a detector.

Generally, there is a need in the art for an approach to implement an improved monolithic fluid sensor system and an improved method for manufacturing the monolithic fluid sensor system.

Such a need can be solved by the monolithic fluid sensor system according to independent claim 1 and by a method for manufacturing a monolithic fluid sensor system according to independent claim 8.

Specific implementations of the monolithic fluid sensor system and the method for manufacturing the monolithic fluid sensor system are defined in the dependent claims.

### Summary

According to an embodiment a monolithic fluid sensor system comprises:
a sensor arrangement having a thermal radiation emitter, an optical filter structure, a waveguide structure and a thermal radiation detector on a first main surface region of a sensor substrate, a cover substrate, wherein a recess is arranged in a first main surface region of the cover substrate and a through-opening is arranged between the recess in the first main surface region and a second main surface region of the cover substrate, wherein the first main surface region of the cover substrate is bonded (fusion bonded - wafer bonded) to the first main surface region of a sensor substrate, wherein the sensor arrangement is arranged below the recess of the cover substrate,
a reference sensor arrangement having a reference thermal radiation emitter, a reference optical filter structure, a reference waveguide structure and a reference thermal radiation detector on a first main surface region of a reference sensor substrate, and
a reference cover substrate, wherein a reference recess is arranged in a first main surface region of the reference cover substrate, wherein the first main surface region of the reference cover substrate is bonded to the first main surface region of the reference sensor substrate, and wherein the reference recess in the first main surface region of the reference cover substrate forms a hermetically closed cavity for the reference sensor arrangement.

Thus, embodiments provide a monolithic fluid sensor system and a method for manufacturing such a monolithic fluid sensor system, wherein the sensor system comprises a sensor arrangement and a reference sensor arrangement which are monolithically arranged, i.e., the respective substrates or semiconductor substrates (wafers or semiconductor wafers) are bonded (fusion bonded or wafer bonded on wafer-level) to each other for providing the resulting monolithic fluid sensor system.

The monolithic fluid sensor system and a method for manufacturing such a monolithic fluid sensor system provide for an inexpensive monolithic on-chip integration of a selective and efficient fluid sensor system for the industrial sector.

### Brief Description of the Drawings

Embodiments of the present monolithic fluid sensor system and the method for manufacturing the monolithic fluid sensor system are described in detail with respect to the drawings and figures, in which:
- Fig. 1: shows a schematic plan view (top view) of a monolithic fluid sensor system according to an embodiment;
- Fig. 2a: shows different schematic 3D representations of different exemplarily wave-guide types for the monolithic fluid sensor system according to an embodiment;
- Fig. 2b: shows exemplary schematic cross-sectional views of a strip waveguide and a slot waveguide together with a simulation of the respective evanescent fields at the resonance wavelength λ₀ according to an embodiment.
- Figs. 3a-e: show schematic cross-sectional views of the monolithic fluid sensor system of Fig. 1 according to an embodiment;
- Fig. 4a-b: shows a principle flowchart of a method for manufacturing a monolithic fluid sensor system according to an embodiment;
- Figs. 5a: shows a schematic cross-sectional view of a monolithic fluid sensor system according to a further embodiment;
- Figs. 5b: shows an exploded view of the different substrates (wafers - before the bonding process) of the monolithic fluid sensor system according to the further embodiment;
- Fig. 6: shows a schematic flowchart of a further method for manufacturing the monolithic fluid sensor system (of Figs. 5a-b) according to a further embodiment;
- Figs. 7a: shows a schematic cross-sectional view of a monolithic fluid sensor system according to a further embodiment;
- Figs. 7b: shows an exploded view of the different substrates (wafers - before the bonding process) of the monolithic fluid sensor system according to the further embodiment; and
- Fig. 8: shows a schematic process flow of the method for manufacturing the monolithic fluid sensor system of Figs. 7a-b according to the further embodiment.

In the following description, embodiments are discussed in further detail using the figures, wherein in the figures and the specification identical elements and elements having the same functionality and/or the same technical or physical effect are provided with the same reference numbers or are identified with the same name. Thus, the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of semiconductor devices. The specific embodiments discussed are merely illustrative of specific ways to make and use the present concept, and do not limit the scope of the embodiments. In the following description of embodiments, the same or similar elements having the same function have associated therewith the same reference signs or the same name, and a description of such elements will not be repeated for every embodiment. Moreover, features of the different embodiments described hereinafter may be combined with each other, unless specifically noted otherwise.

In the description of the embodiments, terms and text passages placed in brackets are to be understood as further explanations, exemplary configurations, exemplary additions and/or exemplary alternatives,

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, some of the figures comprise a Cartesian coordinate system x, y, z, wherein the x-y-plane corresponds, i.e. is parallel, to a first main surface region of a substrate (e.g. a sensor substrate = a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction or a direction parallel to (or in) the x-y-plane, wherein the term "vertical" means a direction parallel to the z-direction.

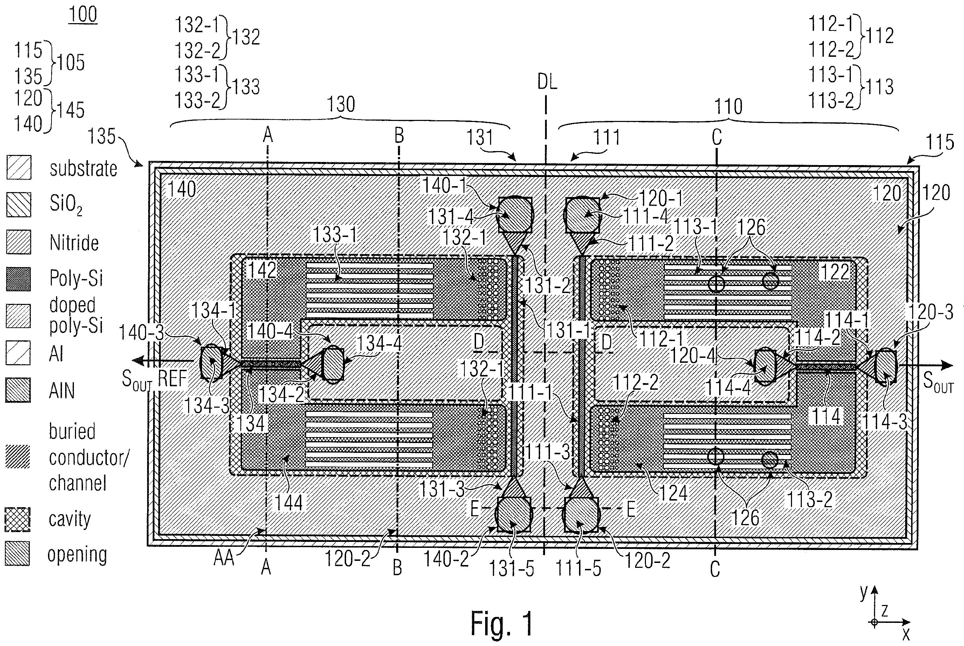

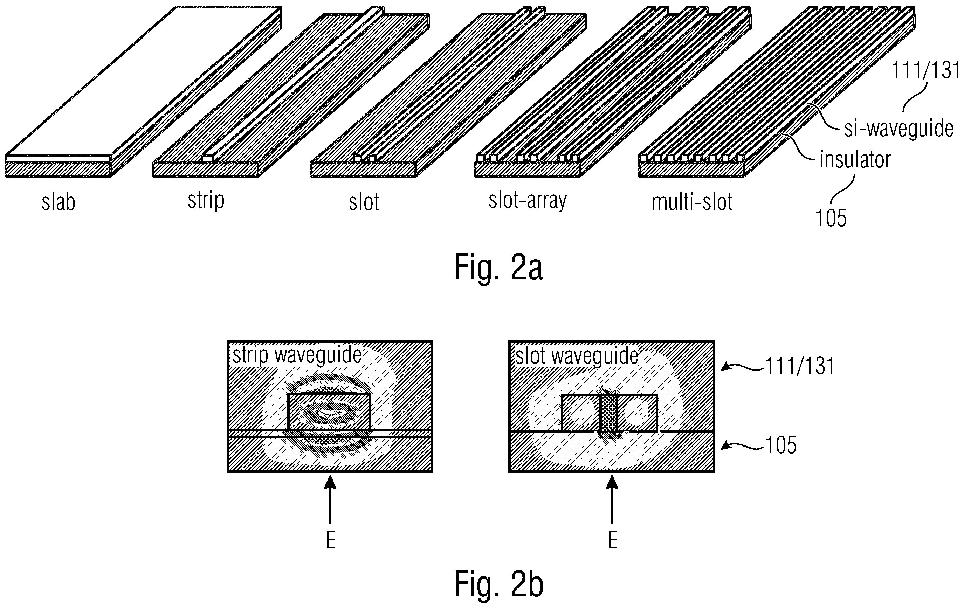

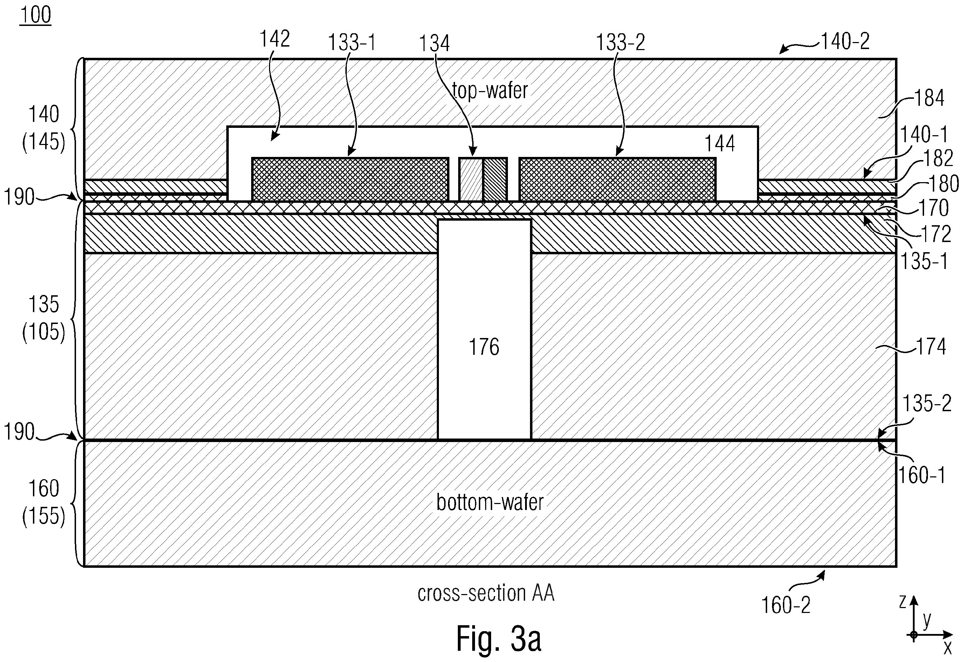

In the following, a monolithic fluid sensor system 100 is described with respect to Figs. 1, 2a-b and 3a-e according to an embodiment. Fig. 1 shows a schematic plan view (top view) of a monolithic fluid sensor system 100 according to an embodiment. Fig. 2a shows different schematic 3D representations of different exemplarily waveguide types for the monolithic fluid sensor system according to an embodiment. Fig. 2b shows exemplary schematic cross-sectional views of a strip waveguide and a slot waveguide together with a simulation of the respective evanescent fields at the resonance wavelength λ₀ according to an embodiment. Figs. 3a-e show schematic cross-sectional views of the monolithic fluid sensor system of Fig. 1.

As shown in Fig. 1, the monolithic fluid sensor system 100 comprises a sensor arrangement (sensor path) 110, a cover substrate 120, a reference sensor arrangement (reference path) 130, and a reference cover substrate 140.

The sensor arrangement 110 comprises a thermal radiation emitter 111, an optical filter structure 112, a waveguide structure 113 and a thermal radiation detector 114 on a first main surface region 115-1 of the sensor substrate 115.

The cover substrate 120 comprises a recess, e.g. a depression or hollow, 122, which is arranged in a first main surface region 120-1 of the cover substrate 120. The cover substrate 120 further comprises a through-opening, e.g. a ventilation opening or ventilation hole, 126 between the recess 122 in the first main surface region 120-1 and a second main surface region 120-2 of the cover substrate. The first main surface region 120-1 of the cover substrate 120 is bonded, e.g., wafer bonded or fusion bonded on wafer-level, to the first main surface region 115-1 of the sensor substrate 115, wherein the sensor arrangement 110 is arranged below the recess 122 of the cover substrate 120.

The recess 122 in the first main surface region 115-1 of the cover substrate 115 forms a (structured) cavity 124 for the sensor arrangement (reference path) 110, and wherein the through-opening 126 forms a fluidic connection to the environment for enabling exchange of fluids between the sensor cavity 124 and the environment. The through-opening 126 in the cavity 124 of the sensor path 110 provides for an interaction (in the cavity 124) with the environmental gas. As exemplarily shown in Fig. 1, the cover substrate 120 may comprises at least one (or a plurality) of through-opening(s) 126.

The reference sensor arrangement 130 comprises a reference thermal radiation emitter 131, a reference optical filter structure 132, a reference waveguide structure 133, a reference thermal radiation detector 134 on a first surface region 135-1 of the reference sensor substrate 135.

The reference cover substrate 140 comprises a reference recess 142, wherein the reference recess 142 is arranged in a first main surface region 140-1 of the reference cover substrate 140. The first main surface region 140-1 of the reference cover substrate is bonded, e.g. wafer bonded or fusion bonded on wafer-level, to the first main surface region 135-1 of the reference sensor substrate 135. The reference recess 142 in the first main surface region 140-1 forms a hermetically closed (e.g. sealed) cavity (= structured cavity) 144 for the reference sensor arrangement (reference path) 130. The reference cover substrate does not comprise a through opening and constitutes therefore a hermetic cavity 144 without an exchange of fluids between the reference sensor cavity 144 and the environment.

According to an embodiment, the waveguide structure 113 of the sensor arrangement 110 may (optionally) comprise a first waveguide portion 113-1 and a second waveguide portion 113-2, which are optically arranged between the thermal radiation emitter 111 and the thermal radiation detector 114. Thus, the thermal radiation emitter 111 (through a first and second optical filter structure portion 112-1, 112-2) couples into the two waveguide portions 113-1, 113-2, which lead to the thermal radiation detector 114. The two waveguide portions 113-1, 113-2 may have (parallel to the reference plane) a L-shape or an arc shape, so that the two waveguide portions 113-1, 113-2 each lead to the thermal radiation detector 114.

According to the embodiment, the reference waveguide structure 133 of the reference sensor arrangement 130 may (optionally) comprise a first reference waveguide portion 133-1 and a second reference waveguide portion 133-2, which are optically arranged between the reference thermal radiation emitter 131 and the reference thermal radiation detector 144. Thus, the reference thermal radiation emitter 131 couples (through a first and second optical filter structure portion 132-1, 132-2) into the two waveguide portions 133-1, 133-2, which lead to the reference thermal radiation detector 134. The two reference waveguide portions 133 may have (parallel to the reference plane) a L-shape or an arc shape, so that the two reference waveguide portions 133 each lead to the reference thermal radiation detector 134.

According to an embodiment, the elements 111, 112, 113, 114 of the sensor arrangement 110 and the corresponding reference elements 131, 132, 133, 134 of the reference sensor arrangement 130 have the same structural setup (composition) and functionality with the exception of the through-opening(s) 126 in the cover substrate 120 which are not present in the reference cover substrate 140.

According to an embodiment, the monolithic fluid sensor system 100 further comprises a bottom substrate 150 (see Figs. 3a-e), wherein a first main surface region 150-1 of the bottom substrate 150 is bonded, e.g. fusion bonded or wafer bonded, to the second main surface region 115-2 of the sensor substrate 115. The monolithic fluid sensor system 110 further comprises a reference bottom substrate 160, wherein a first main surface region 160-1 of the reference bottom substrate 160 is bonded, e.g. fusion bonded or wafer bonded, to the second main surface region 135-2 of the reference senor substrate 135.

Thus, the sensor substrate 115 is sandwiched (in a stacked configuration) between the cover substrate 120 and the bottom substrate 150, wherein the reference sensor substrate 135 is sandwiched (in a stacked configuration) between the reference cover substrate 140 and the reference bottom substrate 160.

According to an embodiment, the sensor substrate 115 and the reference sensor substrate 135 are arranged to form a common system substrate 105, wherein the cover substrate 120 and the reference cover 140 substrate are arranged to form a common cover substrate 145, and wherein the bottom substrate 150 and the reference bottom substrate 160 are arranged to form a common bottom substrate (spacer substrate) 155. Thus, the top main surface region 115-1 of the sensor substrate 115 may form a common system plane of the monolithic fluid sensor system 100.

The term "common substrate" may be also referred to an one-piece substrate or one-piece wafer or, also, as an one piece semiconductor substrate or one-piece semiconductor wafer, or, also, as an one piece glass substrate or one-piece glass wafer.

According to a further embodiment, the sensor substrate 115 and the reference sensor substrate 135 may be arranged to form separate system substrates, wherein the cover substrate 120 and the reference cover substrate 140 may be are arranged to form separate cover substrates, and wherein the bottom substrate 150 and the reference bottom substrate 160 may be arranged to form separate bottom substrates. These substrates may be processed as separated substrates or may be singulated (diced) at the dicing line DL, shown in Fig. 1. Thus, the solutions for the reference complete system 130 and the sensor complete system 110 can both get divided on different layouts regarding production.

The sensor arrangement 110 and the reference sensor arrangement 130 may be formed on different substrates and, thus, may be provided as a sensor chip and a reference sensor chip, which may be placed next to each other in the application. Furthermore, the sensor chip and the reference sensor chip may be fixed or bonded to each other, e.g. by means of chip-stacking, for providing the monolithic fluid sensor system.

The monolithic fluid sensor system 100 is arranged for sensing an amount or a concentration of a target fluid or a target fluid component in the surrounding atmosphere, e.g. an environmental medium. In the present context, the term fluid may related to a liquid or a gas. In case, the environmental medium relates to environmental air, the target fluid may relate to a target gas or a target gas component which is present in the environmental air. Such a target gas or a target gas component may be at least one of CO, CO₂, O₃, NOₓ, and methane, for example. The present concept is equally applicable to sense a target liquid or a target liquid component in the environmental medium.

As shown in Fig. 1, the monolithic fluid sensor system 100 comprises the sensor arrangement 110, which is in fluidic communication with the environmental atmosphere, and the reference sensor arrangement 130, which is arranged in the hermetically closed cavity 144.

According to embodiments of the present disclosure, the monolithic fluid sensor system 100 performs a fluid measurement by means of the sensor arrangement 110 as well as a reference measurement by means of the reference sensor arrangement 110. During the fluid measurement, filtered thermal radiation R₀, which is emitted by the thermal radiation emitter 112 and filtered by the optical filter structure 113, is guided via the waveguide structure 113 to the thermal radiation and detector 114. The sensor arrangement 110 is in fluidic connection to the environmental atmosphere comprising the target fluid to be detected and/or sensed.

The reference sensor arrangement 130 is arranged to perform a reference measurement by guiding a reference thermal radiation R'₀, which is emitted by the reference thermal radiation emitter 131 and filtered by the reference optical filter structure 132, via the reference waveguide structure 133 to the reference thermal radiation detector 134.

In the following, some general technical aspects of the elements of the sensor arrangement 110 and of the reference sensor arrangement 130 are described.

Sensor arrangement 110: The thermal radiation emitter 111 may comprise a semiconductor strip 111-1 for emitting a broadband thermal radiation R, e.g., a broadband IR radiation, at least partially in a main radiation emission direction parallel to the first main surface region 115-1 of the sensor substrate 115. Thus, the thermal radiation emitter 111 may be formed as a doped poly-Si wire emitter. At least a part of the emitted thermal radiation is in the IR wavelength range between 0,7 µm and 1 mm, or between 1 µm and 20 µm. Thus, the emitted thermal radiation is infrared (IR) radiation or comprises infrared (IR) radiation.

The semiconductor strip 111-1 may form a black body radiator (= thermal radiation emitter) and may be configured to have in an actuated condition an operating temperature in a range between 600° K and 1000° K or between 600° K and 800° K. Thus, according to an embodiment, a free standing (isolated) highly n-doped polysilicon wire 111-1 is provided as the thermal radiation emitter 111, that emits broadband IR radiation proportionally to the Planck's radiation law.

According to an embodiment, the thermal radiation emitter 111 may be connected via a first and a second buried conductor 111-2, 111-3 to a first and a second terminal (metal pads) 111-4, 111-5. The first and second terminal (metal pads) 111-4, 111-5 may be electrically connected (by means of wire bonding) to a power source for providing the thermal radiation emitter 111 with electrical energy to bring the thermal radiation emitter 111 in the actuated condition. The cover substrate 120 may comprise openings or holes 120-1, 120-2 for contacting (wire bonding) the metal pads 111-4, 111-5.

The sensor arrangement 110 further comprises the optical filter structure 112 (with the first and second optical filter structure portions 112-1, 112-2) on the top main surface region 115-1 of the sensor substrate 115. The optical filter structure 112 may comprises a semiconductor material and is configured to filter the broadband thermal radiation R (= broadband IR radiation) emitted by the thermal radiation emitter 111 and to provide a filtered (= narrowband) IR radiation R₀ (= filtered thermal radiation) having a center wavelength λ₀ for achieving a maximum interaction or absorption of the filtered thermal radiation R₀ with the target fluid. Thus, the optical filter structure 130 adjusts the filtered thermal radiation R₀ to match the absorption spectrum of the target fluid (target medium). The optical filter structure 112 of the sensor arrangement 110 may be formed as an optical resonator structure having a narrow transmission band with the center wavelength λ₀. According to an embodiment, the optical filter structure 112 may comprise at least one of a photonic crystal structure (photonic filter) and/or a Bragg filter structure as wavelength selective optical element(s) for providing the filtered (= narrowband) IR radiation R₀ having the center wavelength λ₀.

The sensor arrangement 110 further comprises the waveguide structure 113 (with the two parallel waveguide portions 113-1, 113-2) on the main top surface region 115-1 of the sensor substrate 115. The filtered narrowband IR radiation R₀ having the center wavelength λ₀ is at least partially coupled into the waveguide structure 113, wherein a mode of the filtered IR radiation R₀ propagates in the waveguide 113. The waveguide structure 113 may comprise a semiconductor material and is configured to guide the filtered IR radiation having the center wavelength λ₀ (e.g. by total reflection). The guided IR radiation R₀ comprises an evanescent field component, i.e., a field component outside the waveguide 113, for interacting with the surrounding atmosphere comprising the target fluid, i.e., a target liquid or a target gas.

As shown in the schematic plane view of Fig. 1, the waveguide structure 113 may comprise a multi-slot waveguide with seven strips, for example. The multi-slot waveguide may comprise of at least two (2 to n) strips of high refractive index materials n_{H} separated by a sub-wavelength-scale slot region having a low-refractive index n_{L} and surrounded by the environmental medium, e.g. air, having a low-refractive-index n_{AIR}. The multi-slot waveguide is an optical waveguide that guides strongly confined light (= the filtered thermal radiation R₀) in the slot region. Thus, a multi-slot waveguide may be used because the orientation and the strength of the evanescent field accumulated due to the overlapping fields between the at least two strips of the multi-slot waveguide.

The filtered IR radiation R₀ guided by the waveguide structure 113 comprises an evanescent field component E for interacting with the surrounding atmosphere having the target fluid, wherein the interaction of the evanescent field component E with the surrounding atmosphere results in a reduction of the transmitted thermal radiation R₀ due to absorption of the guided radiation R₀ which is a measure for the target fluid concentration in the surrounding atmosphere or medium.

Fig. 2a shows different schematic 3D representations of different exemplarily waveguide types for the monolithic fluid sensor system according to an embodiment. According to further embodiments, other waveguide types, e.g., at least one of a slab waveguide, a strip waveguide, a slot waveguide, a slot-array waveguide and a multi-slot waveguide, etc., may be used for the waveguide structure 113.

Fig. 2b shows exemplary schematic cross-sectional views of a strip waveguide and a slot waveguide together with a simulation of the respective evanescent fields "E" at the filtered (resonance) wavelength λ₀ according to an embodiment.

To summarize, the sensor arrangement 110 of the monolithic fluid sensor system 100 may comprise a so-called multi-slot waveguide 113, wherein in the multi-slot waveguide, an electromagnetic mode propagates in the infrared wavelength range, wherein a significant part of the mode, i.e. the evanescent field E, propagates outside the waveguide structure 113. Due to the specific design of the multi-slot waveguide, a large portion of the mode propagates in the slots between two strips or slabs of the waveguide. Thus, an evanescent field proportion of several 10% is possible in multi-slot waveguides.

As further shown in Fig. 1, the sensor arrangement 110 further comprises the thermal radiation detector or IR detector (= IR receiver) 114 on the top main surface region 115-1 of the sensor substrate 115, wherein the waveguide structure 113 is optically arranged between the thermal radiation emitter 111 and the thermal radiation detector 114. The thermal radiation detector 114 may comprise at least one of a pyroelectric temperature sensor, a piezoelectric temperature sensor, a pn junction temperature sensor, a piled diode and a resistive temperature sensor.

According to an embodiment, the thermal radiation detector 114 may be connected via a first and a second buried conductor 114-1, 114-2 to a first and a second terminal (metal pads) 114-3, 114-4. The thermal radiation detector 114 is further configured to provide a detector output signal S_{OUT} based on a radiation strength (= signal strength) of the filtered IR radiation R received from the waveguide structure 113. The thermal radiation detector 114 may provide the detector output signal S_{OUT} between the first and second detector terminal 114-3, 114-4. The cover substrate 120 may comprise openings or holes 120-3, 120-4 for contacting (wire bonding) the metal pads 114-3, 114-4.

According to an embodiment, the elements of the sensor arrangement 110 and the reference elements of the reference sensor arrangement 130 may have the same structural setup and (principal) functioning. Thus, the above evaluations of the elements (i.e. the thermal radiation emitter 111, the optical filter structure 112, the waveguide structure 113 and the thermal radiation detector 114, respectively) of the sensor arrangement 110 are equally applicable to the corresponding elements (i.e. the reference thermal radiation emitter 131, the reference optical filter structure 132, the reference waveguide structure 133 and the reference thermal radiation detector 134, respectively) of the reference sensor arrangement 130.

Reference sensor arrangement 130: The reference thermal radiation emitter 131 may comprise a reference semiconductor strip 131-1 for emitting a reference broadband thermal radiation R, e.g., a broadband IR radiation, at least partially in a main radiation emission direction parallel to the first main surface region 135-1 of the reference sensor substrate 115. Thus, the reference thermal radiation emitter 131 may be formed as a doped poly-Si wire emitter.

According to an embodiment, the reference thermal radiation emitter 131 may be connected via a first and a second buried conductor 131-2, 131-3 to a first and a second terminal (metal pads) 131-4, 131-5. The first and second terminal (metal pads) 131-4, 131-5 may be electrically connected (by means of wire bonding) to a power source for providing the reference thermal radiation emitter 131 with electrical energy to bring the reference thermal radiation emitter 131 in the actuated condition. The reference cover substrate 140 may comprise openings or holes 140-1, 140-2 for contacting (wire bonding) the metal pads 131-4, 131-5.

The reference sensor arrangement 130 further comprises the optical filter structure 132 (with the first and second optical filter structure portion 132-1, 132-2) on the top main surface region 135-1 of the reference sensor substrate 135 for filtering the broadband thermal radiation (= broadband IR radiation) emitted by the thermal radiation emitter 131 and to provide the filtered (= narrowband) IR radiation R₀ (= filtered thermal radiation) having a center wavelength λ₀.

The reference sensor arrangement 130 further comprises the reference waveguide structure 133 (with the two, parallel reference waveguide portions 133-1, 133-2) on the main top surface region 135-1 of the reference sensor substrate 135. The filtered narrowband IR radiation R₀ having the center wavelength λ₀ is at least partially coupled into the waveguide structure 133, wherein a mode of the filtered IR radiation R₀ propagates in the waveguide 133. The waveguide structure 133 may comprise a multi-slot waveguide. According to further embodiments, other waveguide types, e.g., at least one of a slab waveguide, a strip waveguide, a slot waveguide, a slot-array waveguide and a multi-slot waveguide, etc., may be used for the waveguide structure 133.

The reference sensor arrangement 130 further comprises the thermal radiation detector or IR detector (= IR receiver) 134 on the top main surface region 135-1 of the reference sensor substrate 135, wherein the reference waveguide 133 is optically arranged between the reference thermal radiation emitter 131 and the reference thermal radiation detector 134. The thermal radiation detector 134 may comprise at least one of a pyroelectric temperature sensor, a piezoelectric temperature sensor, a pn junction temperature sensor, a piled diode and a resistive temperature sensor. The reference thermal radiation detector 134 is further configured to provide a reference detector output signal S_{OUT-REF} based on a radiation strength (= signal strength) of the filtered IR radiation R₀ received from the reference waveguide structure 133. The thermal radiation detector 134 may provide the detector output signal S_{OUT} via a first and a second buried conductor 134-1, 134-2 to a first and second detector terminal 134-3, 134-4.

In the following, the technical effect of commonly using the sensor arrangement 110 and the reference sensor arrangement 130 are described. In order to suppress specific environmental impacts on the measurement, the reference cover substrate 140 is configured to provide the hermetically closed cavity 144 for the reference sensor arrangement 130. For example, an influence of an ambient fluid on the guided radiation, e.g. on an evanescence field of the guided radiation, guided by the reference waveguide structure 133, may be suppressed or reduced by physically blocking the fluid with the reference cover substrate 140 from the reference sensor arrangement 130. Other environmental impacts, for example a temperature, may still influence the reference measurement and the sensor measurement.

The reference measurement of the guided radiation with reduced environment impacts may be used in order to determine an information about unsuppressed environmental effects, e.g. temperature or humidity, or an impact of said effects on the guided radiation that are not or only to a limited amount influenced by the reference cover substrate 140. This information may be used to correct other sensor measurements of the sensor arrangement 110 that are impacted by the environment in the same, or approximately same, manner as the reference measurement of the reference sensor arrangement 110. Consequently, a reference measurement with the reference sensor arrangement 130, using a similar setup to the sensor arrangement 110 may be used to correct or adapt the measurement results of the sensor arrangement 110.

Moreover, not only environmental influences may be determined or compensated in that way. With the reference measurement, and for example an evaluation of a measurement trend over time, sensor parameters or a sensor condition, for example aging of the sensor arrangement 110 and/or fluctuations of the supply voltage, may be determined or taken into account for a compensation or improvement of other measurements of the sensor arrangement 110.

Figs. 3a-e show different schematic cross-sectional views through different sections and elements of the sensor arrangement 110 and the reference sensor arrangement 130 of the monolithic fluid sensor system of Fig. 1 according to the embodiment.

The monolithic fluid sensor system 100 comprises the sensor arrangement 110 on the sensor substrate 115, the cover substrate 120, the reference sensor arrangement 130 on the reference sensor substrate 135, and a reference cover substrate 140.

As shown in Figs. 3a-e the sensor substrate 115 and, accordingly, the reference sensor substrate 135 may optionally comprise a plurality of (stacked) layers e.g., a first insulating (= dielectric) layer 170, a second insulating (= dielectric) layer 172 and a semiconductor substrate layer 174. The first dielectric layer 170 may comprise nitride material, e.g. SiN, the second dielectric layer 172 may comprise an oxide material, e.g. BOX = buried oxide, such as SiO₂, and the semiconductor substrate layer 174 may comprise silicon. Thus, the first main surface region of the first dielectric layer 170 forms the top main surface region 115-1 of the sensor substrate 115 and the top main surface region 135-1 of the reference sensor substrate 135, respectively, e.g. on the complete semiconductor substrate layer 174.

As further shown in Figs. 3a-e the cover substrate 120 and, accordingly, the reference cover substrate 140 may optionally comprise a plurality of (stacked) layers e.g., a first insulating (= dielectric) layer 180, a second insulating (= dielectric) layer 182 and a semiconductor substrate layer 184. The first dielectric layer 180 may comprise nitride material, e.g. SiN, the second dielectric layer 182 may comprise an oxide material, e.g. BOX = buried oxide, such as SiO₂, and the semiconductor substrate layer 184 may comprise silicon. Thus, the first main surface region of the first dielectric layer 180 forms the top main surface region 120-1 of the cover substrate 120 and the top main surface region 140-1 of the reference cover substrate 140, respectively, e.g. on the complete semiconductor substrate layer 180.

The first insulating layer 170, 180 may comprise a thickness between 50 to 500 nm, between 100 and 200 nm, or about 140 nm. The second insulating layer 172, 182 may comprise a thickness between 500 to 5000 nm, between 1500 and 2500 nm, or about 2000 nm.

The semiconductor structures or elements of the sensor arrangement 110 and the reference sensor arrangement 130 may comprise a semiconductor element layer, e.g. having a Poly-Si material, on the first insulating layer 170. The semiconductor element layer may comprise a thickness between 50 to 500 nm, between 100 and 220 nm, or about 160 nm. This semiconductor element layer is provided with an uniform height to form and define at least partially the thermal emitter 111, 131, the optical filter structure 112, 132, the waveguide structure 113, 133 and the thermal detector 114, 134 of the sensor arrangement 110 and the reference sensor arrangement 130.

The thermal heater (Poly heater) 111, 131 may be doped with a dopant, e.g. phosphor, for providing the heating property, and doping the thermal detector 114, 134 with a dopant, e.g. phosphor, for providing the thermal detector 114, 134 with an absorbing property for the thermal radiation (IR radiation).

Thus, the sensor arrangement 110 and the reference sensor arrangement 130 of the monolithic fluid sensor system 100 can be manufactured based on inexpensive CMOS processes.

As further shown in Figs. 3a-e, the first main surface region 120-1 of the cover substrate 120 is bonded, e.g., wafer bonded or fusion bonded on wafer-level, to the first main surface region 115-1 of the sensor substrate 115, wherein the sensor arrangement 110 is arranged below the recess 122 of the cover substrate 120. The first main surface region 150-1 of the bottom substrate 150 is bonded, e.g. fusion bonded or wafer bonded, to the second main surface region 115-2 of the sensor substrate 115. The first main surface region 140-1 of the reference cover substrate is bonded, e.g. wafer bonded or fusion bonded on wafer-level, to the first main surface region 135-1 of the reference sensor substrate 135, wherein the reference sensor arrangement 130 is arranged below the reference recess 142 of the reference cover substrate 120. The first main surface region 160-1 of the reference bottom substrate 160 is bonded, e.g. fusion bonded or wafer bonded, to the second main surface region 135-2 of the reference senor substrate 135. Thus, the sensor substrate 115 is sandwiched (in a stacked configuration) between the cover substrate 120 and the bottom substrate 150, wherein reference sensor substrate 135 is sandwiched (in a stacked configuration) between the reference cover substrate 140 and the reference bottom substrate 160. The respective bonding areas (bonding regions) 190 between the bonded substrates are indicated in Figs. 3a-e.

The enlarged schematic cross-sectional view through the monolithic fluid sensor system 100 in Fig. 3a along the section line "AA" of Fig. 1 shows the reference thermal radiation detector (= IR receiver) 134 and (a part of) the reference waveguide structure 133 on the top main surface region 135-1 of the reference sensor substrate 135 and in the reference sensor cavity 144 below the recess 142 in the first main surface region 140-1 of the reference cover substrate 140.

As shown in Fig. 3a, a cavity 176 is arranged in the sensor substrate 135 (i.e. in the second dielectric layer 172 and the semiconductor layer 174) vertically below the reference thermal radiation detector 134. The formation of the cavity 176 in the reference sensor substrate 135 below the thermal radiation detector 134 reduces the heat transfer from the reference thermal radiation detector 134 into the adjacent material so that the detection efficiency of the reference thermal radiation detector 134 can be increased.

The explanations with respect to Fig. 3a equally apply to the thermal radiation detector (= IR receiver) 114 on the sensor substrate 115 of the sensor arrangement 110.

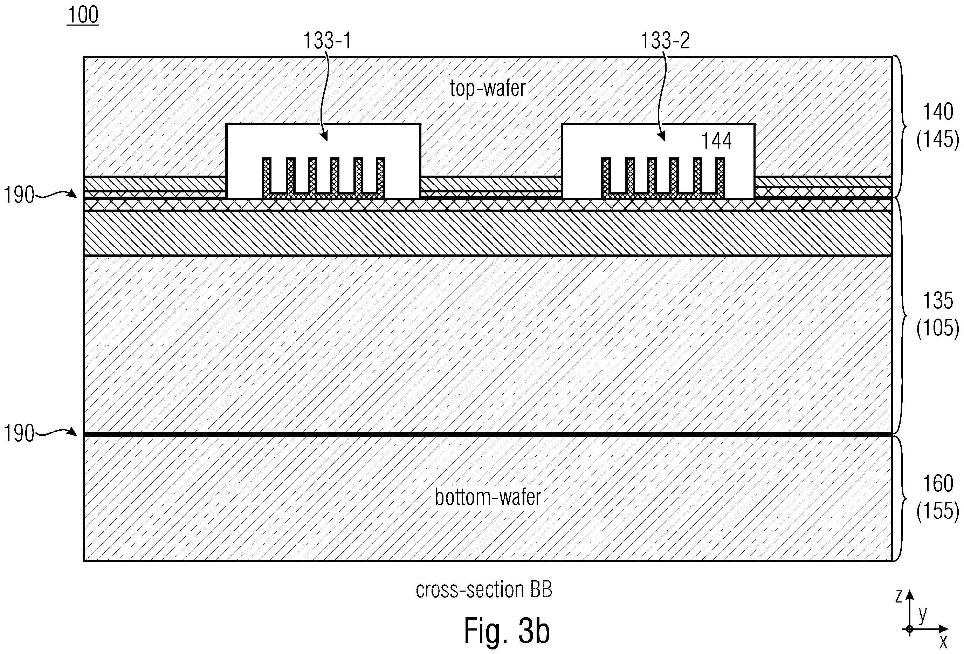

The enlarged cross-sectional view of Fig. 3b along the section line "BB" of Fig. 1 shows the portion of the reference multi-slot waveguide 133 having six strips on the top main surface region 135-1 of the reference sensor substrate 135 and in the reference sensor cavity 144 below the recess 142 in the first main surface region 140-1 of the reference cover substrate 140. The reference recess 142 in the first main surface region 140-1 in the reference cover substrate 140 forms a hermetically closed cavity 144 for the reference sensor arrangement 130. Thus, the reference cover substrate 140 hermetically closes (seals) the cavity 144 without a fluid exchange between the reference sensor cavity 144 and the environment.

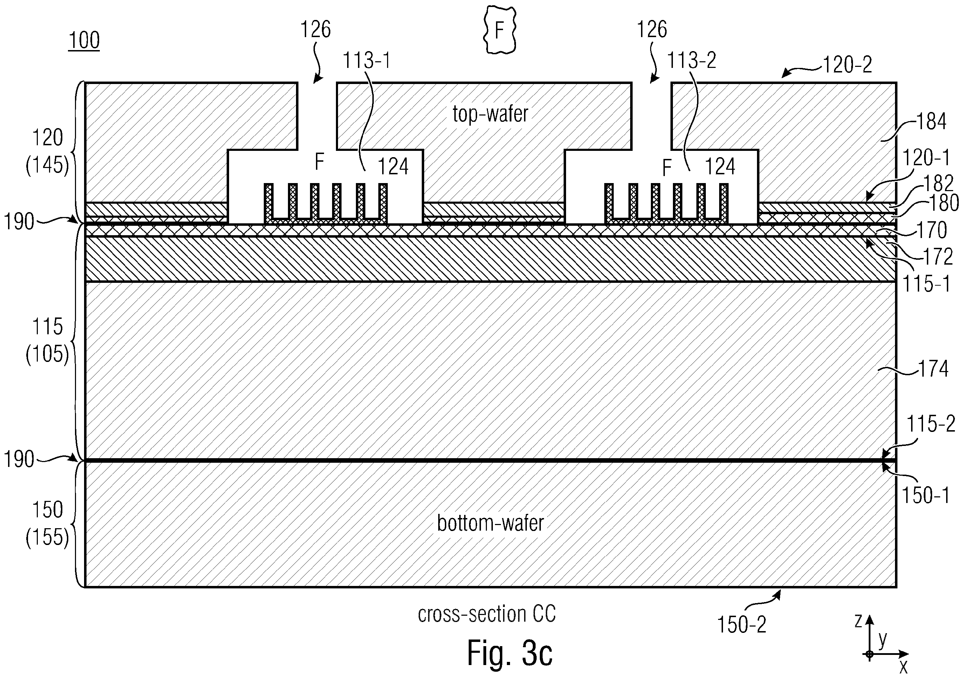

The enlarged schematic cross-sectional view through the monolithic fluid sensor system 100 in Fig. 3c along the section line "CC" of Fig. 1 shows the portion of the multi-slot waveguide having six strips on the top main surface region 115-1 of the sensor substrate 115 and in the sensor cavity 124 below the recess 122 in the first main surface region 120-1 of the cover substrate 120. As shown in Fig. 3c, the through-opening(s) 126 between the recess 122 in the first main surface region 120-1 and a second main surface region 120-2 of the cover substrate forms a fluidic connection to the environment for enabling exchange of fluids between the sensor cavity 124 and the environment.

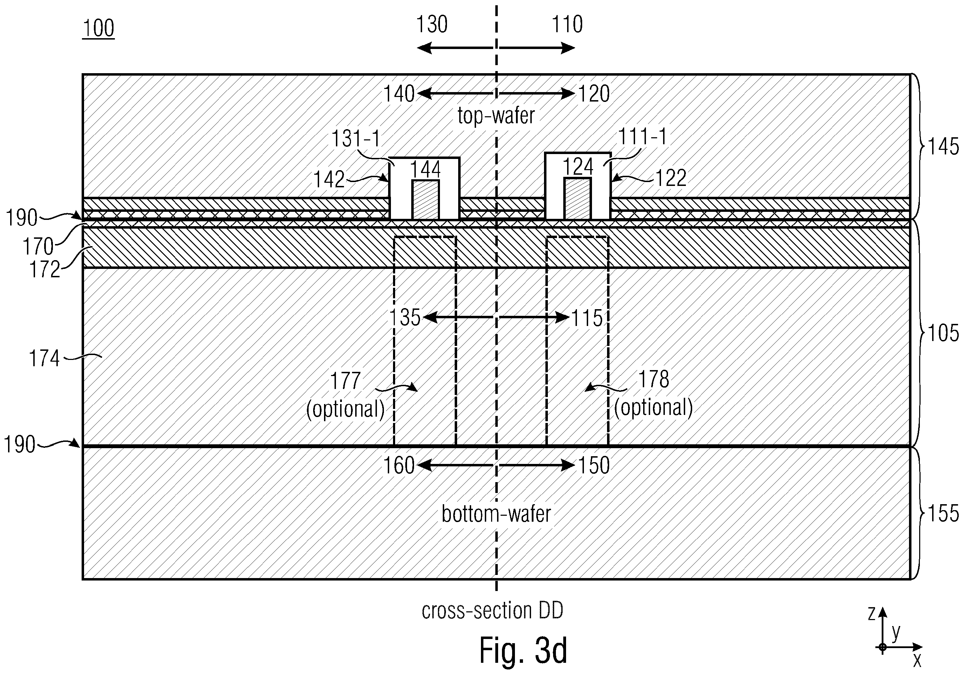

The enlarged schematic cross-sectional view through the monolithic fluid sensor system 100 in Fig. 3d along the section line "DD" of Fig. 1 shows the semiconductor strip 111-1 of the thermal radiation emitter 111 on the top main surface region 115-1 of the sensor substrate 115 and in the sensor cavity 124 below the recess 122 in the first main surface region 120-1 of the cover substrate 120 and, further, the reference semiconductor strip 131-1 of the reference thermal radiation emitter 131 on the top main surface region 135-1 of the reference sensor substrate 135 and in the reference sensor cavity 144 below the reference recess 142 in the first main surface region 140-1 of the reference cover substrate 140.

Optionally, a cavity 177, 178 may be also arranged vertically below the thermal radiation emitter 111 and the reference thermal radiation emitter 131 (= emitter 11, 131). The formation of a cavity 177, 178 in the substrate 115, 135 below the emitter 111, 131 reduces the heat transfer from the emitter 111, 131 into the adjacent material so that the emission efficiency of the emitter 111, 131 can be increased.

The first insulating (= dielectric) layer 170 and the second insulating (= dielectric) layer 172 can be seen as an insulating layer stack to decouple the waveguide structures 113, 131 from the substrate 115, 135 and to provide a membrane for the emitter structure 111, 131 and detector structure 114, 134 as the substrate is removed under these structures" or on the substrate itself.

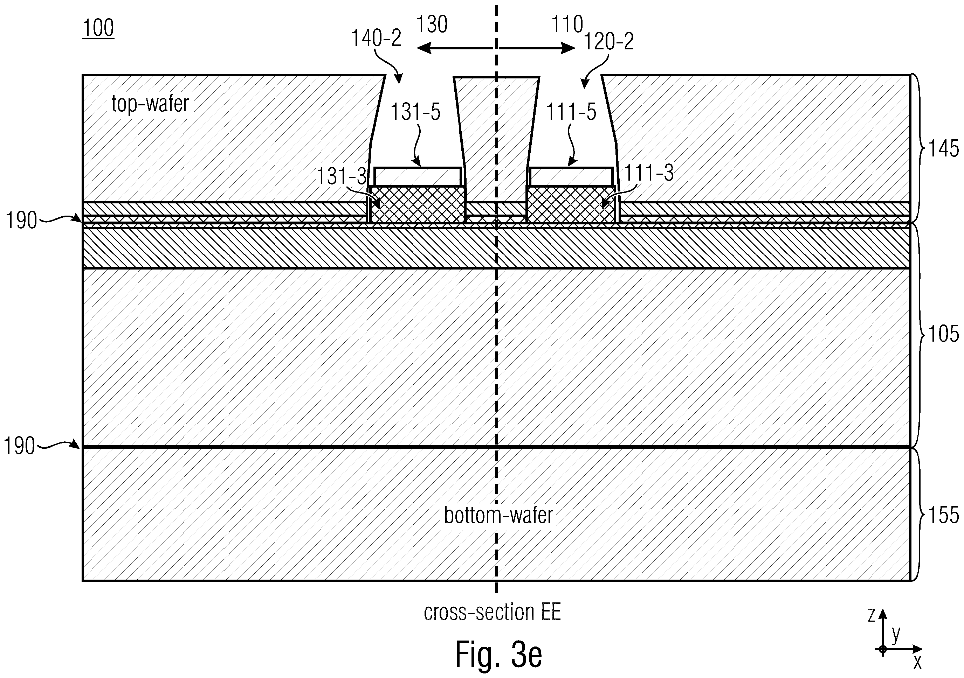

The enlarged schematic cross-sectional view through the monolithic fluid sensor system 100 in Fig. 3e along the section line "EE" of Fig. 1 shows the second terminal (metal pads) 111-5, 131-5 for the thermal radiation emitter 111 on the sensor substrate 115 and the reference thermal radiation emitter 131 on the reference sensor substrate 135, e.g. on the one-piece substrate 145 (115, 135). According to an embodiment, the thermal radiation emitter 111, 131 may be connected via a first and second buried conductor 111-3, 131-3 to the first and second terminals 111-4, 111-5 and 131-4, 131-5 (terminals 111-4 and 131-4 are not shown in Fig. 3e). The cover substrate 120 and reference cover substrate 140, respectively, comprises openings or holes 120-1, 120-2, 140-1, 140-2 (openings 120-1 and 140-1 are not shown in Fig. 3e) for contacting, e.g. wire bonding, the metal pads 111-4, 111-5 and 131-4, 131-5.

Summary of the above embodiments: The described approach of the present monolithic fluid sensor system 100 provides an efficient utilization of the emitter radiation based on a thermal emitter. This can be achieved when using waveguides. Using waveguides may entail coupling losses, which is a known effect. However, using two waveguides which are each guided to a detector results in an increase in the area for interaction with the gas to be sampled. The detector takes advantage from being heated from both sides.

Moreover, a reference measurement of the guided radiation may be used to determine an information about unsuppressed environmental effects, e.g. temperature or humidity, or an impact of side effects on the guided radiation. This information may be used to correct other sensor measurements of the sensor arrangement that are impacted by the environment in the same, or approximately same, manner as the reference measurement of the reference sensor arrangement. Consequently, a reference measurement with the reference sensor arrangement, using a similar setup to the sensor arrangement may be used to correct or adapt the measurement results of the sensor arrangement.

Such an approach synergistically combines the following exemplary aspects:
- High energy efficiency: most efficient utilization possible of the emitted radiation
- form factor: the two-times double waveguide concept offers high interaction between radiation and gas on a comparatively small area
- Highly sensitive: an improved resolution can be obtained by more radiation power impinging on the detector
- Monolithic sensor system
- Reference path: realized by means of a (e.g. Si) wafer bond in the form of a concept which allows both interaction with the ambient gas (in the sensor arrangement) and forming cavities for the reference sensor arrangement, and which integrates a shielding which protects from wave absorption by the (e.g. Si) cover.

The waveguide structure 113, 133 according to examples of the disclosure, e.g. a twin WG (for example a waveguide structure comprises a first and second waveguide section) may provide for more area for interacting with an analyte, i.e. a larger interacting area with the surrounding fluid, e.g. gas to be sampled. Additionally, the detector may be heated from more than one, e.g. both sides.

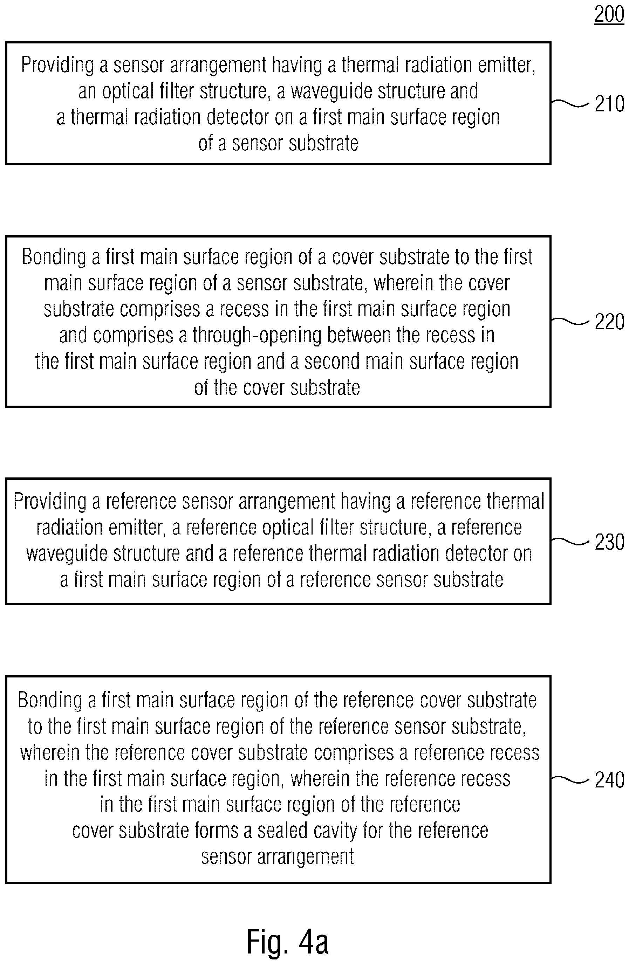

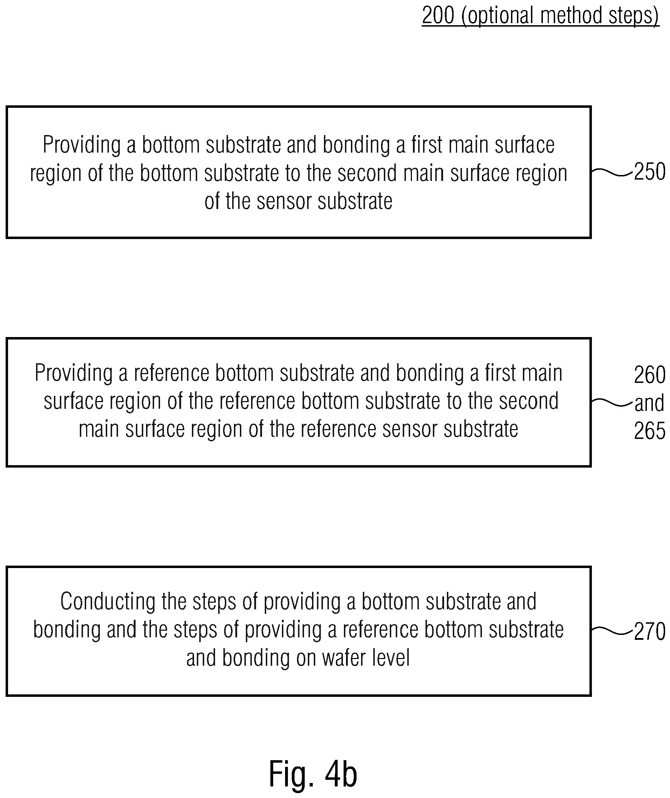

Fig. 4 shows a principle flowchart of a method 200 for manufacturing the monolithic fluid sensor system 100 according to an embodiment, such as the monolithic fluid sensor system 100 of Figs. 1, 2a-b and 3a-e.

The method 200 for manufacturing a monolithic fluid sensor system 100 may comprise
- the step 210 of providing a sensor arrangement 110 having a thermal radiation emitter 111, an optical filter structure 112, a waveguide structure 113 and a thermal radiation detector 114 on a first main surface region 115-1 of a sensor substrate 115,
- the step 220 of bonding, e.g. wafer or fusion bonding, a first main surface region 120-1 of a cover substrate 120, e.g. a semiconductor substrate, to the first main surface region 115-1 of a sensor substrate 115, wherein the cover substrate 120 comprises a recess 122 in the first main surface region 120-1 and comprises a through-opening 124 between the recess 122 in the first main surface region 120-1 and a second main surface region 120-2 of the cover substrate 120,
- the step 230 of providing a reference sensor arrangement 130 having a reference thermal radiation emitter 131, a reference optical filter structure 132, a reference waveguide structure 133 and a reference thermal radiation detector 134 on a first main surface region 135-1 of a reference sensor substrate 135, and
- the step 240 of bonding a first main surface region 140-1 of the reference cover substrate 140 to the first main surface region 135-1 of the reference sensor substrate 135, wherein the reference cover substrate 140 comprises a reference recess 142 in the first main surface region 140-1, wherein the reference recess 142 in the first main surface region 140-1 of the reference cover substrate 140 forms a hermetically closed (sealed) cavity 144 for the reference sensor arrangement 130.

According to an embodiment, the method steps of providing 210 the sensor arrangement 110, of bonding 220 the first main surface region of the cover substrate 120 to the first main surface region of the sensor substrate 115, of providing 230 the reference sensor arrangement 130, and of bonding 240 the first main surface region of the reference cover substrate 140 to the first main surface region of the reference sensor substrate 120 are conducted on wafer level.

Thus, the sensor substrate 115 may be a sensor wafer, the cover substrate 120 may be a cover wafer, the reference sensor substrate 135 may be a reference sensor wafer, and the reference cover substrate 140 may be a reference cover wafer. Further, the respective substrates may be singulated (= diced) parts (= chips) of an associated wafer.

Wafer bonding is a bonding and packaging technology on wafer-level for the fabrication, for example, of microelectromechanical systems (MEMS), ensuring a mechanically stable and hermetically closed connection between the bonded areas (regions) of the bonded wafers. The term wafer bonding my relate to bonding techniques, such as direct bonding, surface activated bonding, anodic bonding, eutectic bonding, glass frit bonding adhesive bonding thermos-compression bonding, reactive bonding, transient liquid phase diffusion bonding, etc.

According to embodiments, the term wafer bonding may especially relate fusion bonding (= direct bonding). Fusion bonding describes a wafer bonding process without any "additional" intermediate layers, i.e. in addition to the (optional) first insulating (= dielectric) layer 170, 180 (e.g. a nitride material, such as SiN), the (optional) second insulating (= dielectric) layer 172, 182 (e.g. an oxide material, e.g. BOX = buried oxide, such as SiO₂), and the semiconductor substrate layer 174, 184 (e.g. a silicon layer). The bonding process is based on chemical bonds between two surfaces of any material possible meeting the bonding requirements, such as between opposing nitride layers 170, 180, oxide layers 172, 182 or semiconductor layers 174, 184. The procedural steps of the direct bonding process of wafers any surface may divided into 1. wafer preprocessing, 2. pre-bonding at room temperature and 3. annealing at elevated temperatures, for example.

As exemplarily shown in Fig. 4b, the method 200 for manufacturing a monolithic fluid sensor system 100 may further comprise the step 250 of providing a bottom substrate 150 and bonding a first main surface region 150-1 of the bottom substrate 150 to the second main surface region 115-2 of the sensor substrate 115, and the step 260 providing a reference bottom substrate 160 and bonding 265 a first main surface region 160-1 of the reference bottom substrate 160 to the second main surface region 135-2 of the reference sensor substrate 135.

Thus, the bottom substrate 150 may be a bottom wafer and the reference bottom substrate 160 may be a reference bottom wafer. Further, the respective substrates may be singulated (= diced) parts (= chips) of an associated wafer.

According to a further embodiment, the sensor substrate 115 and the reference sensor substrate 135 are arranged to form a common system substrate 105, wherein the cover substrate 120 and the reference cover substrate 140 are arranged to form a common cover substrate 145, and wherein the bottom substrate 150 and the reference bottom substrate 160 are arranged to form a common bottom substrate 155.

According to an embodiment, the bonding steps 220, 240, 250, 260 may be conducted with the common system substrate 105, the common cover substrate 145 and the common bottom substrate 155. The term "common substrate" may be also referred to an one-piece substrate or one-piece wafer or, also, as an one piece semiconductor substrate or one-piece semiconductor wafer, or, also, as an one piece glass substrate or one-piece glass wafer.

The method 200 for manufacturing a monolithic fluid sensor system 100 may further comprise the step 270 of conducting the steps of providing a bottom substrate and bonding and the steps of providing a reference bottom substrate and bonding on wafer level.

According to a further embodiment, the sensor substrate 115 and the reference sensor substrate 135 may arranged to form separate system substrates, wherein the cover substrate 120 and the reference cover substrate 140 are arranged to form separate cover substrates, and wherein the bottom substrate 150 and the reference bottom substrate 160 are arranged to form separate bottom substrates. These substrates may be singulated (diced) at the dicing line DL, shown in Fig. 1.

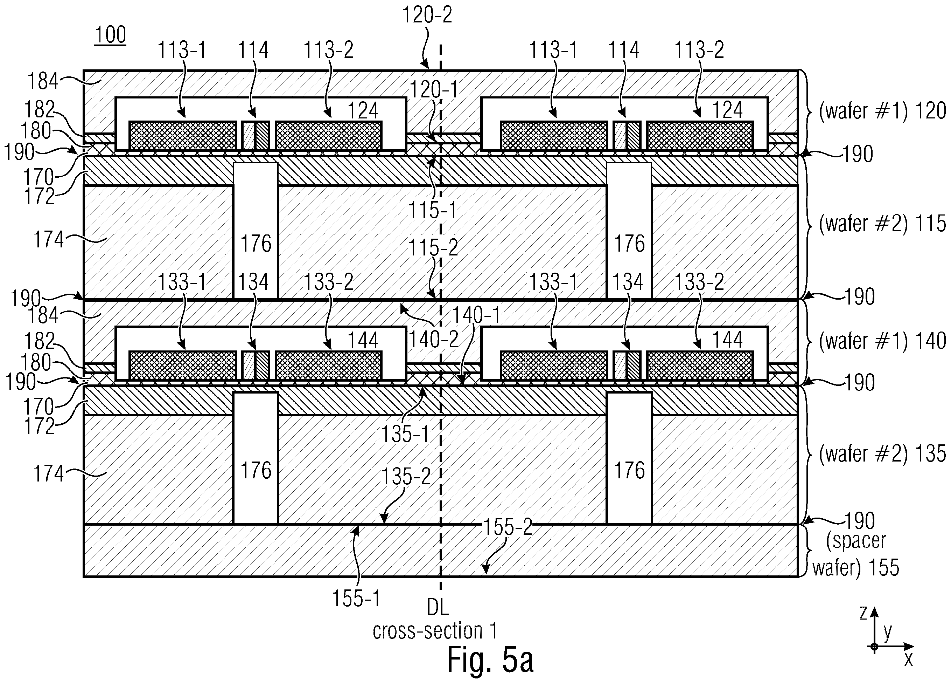

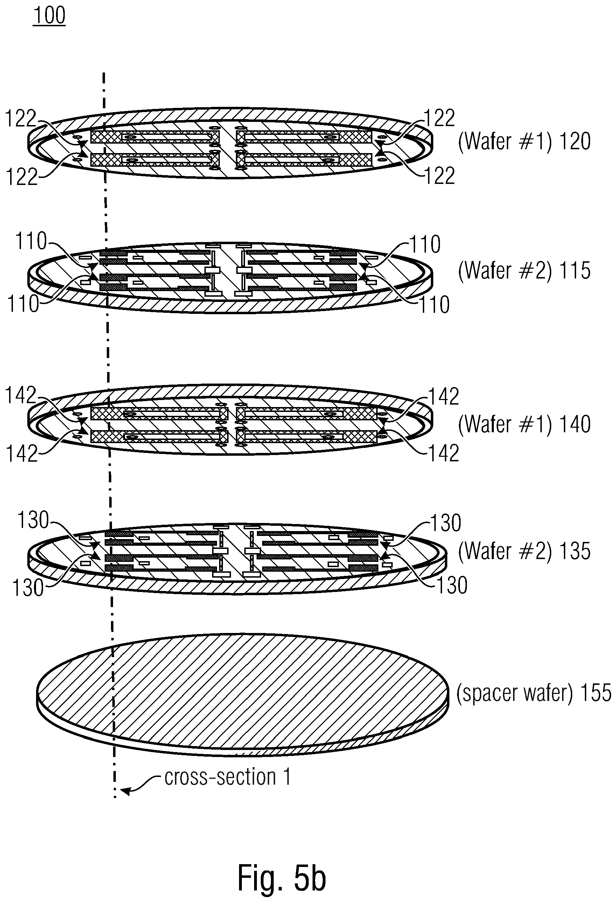

In the following, a further embodiment of the monolithic fluid sensor system 100 is described with respect to Figs. 5a-b. Figs. 5a shows a schematic cross-sectional view of a monolithic fluid sensor system according to a further embodiment. Figs. 5b shows an exploded view of the different substrates (wafers - before the bonding process) of the monolithic fluid sensor system 100 according to the further embodiment.

Also referring to in Fig. 1, 2a-b and 3a-e, the monolithic fluid sensor system 100 comprises the sensor arrangement (sensor path) 110, the cover substrate 120, the reference sensor arrangement (reference path) 130, and the reference cover substrate 140. The sensor arrangement 110 comprises the thermal radiation emitter 111, the optical filter structure 112, the waveguide structure 113 and the thermal radiation detector 114 on the first main surface region 115-1 of the sensor substrate 115.

The cover substrate 120 comprises the recess, e.g. depression or hollow, 122, which is arranged in the first main surface region 120-1 of the cover substrate 120. The cover substrate 120 further comprises the through-opening, e.g. a ventilation opening or ventilation hole, 126 between the recess 122 in the first main surface region 120-1 and the second main surface region 120-2 of the cover substrate. The first main surface region 120-1 of the cover substrate 120 is bonded, e.g., wafer bonded or fusion bonded on wafer-level, to the first main surface region 115-1 of the sensor substrate 115, wherein the sensor arrangement 110 is arranged below the recess 122 of the cover substrate 120.

The recess 122 in the first main surface region 115-1 of the cover substrate 115 forms the (structured) cavity 124 for the sensor arrangement (reference path) 110, wherein the through-opening 126 forms the fluidic connection to the environment for enabling exchange of fluids between the sensor cavity 124 and the environment. The through-opening 126 in the cavity 124 of the sensor path 110 provides for an interaction (in the cavity 124) with the environmental gas.

The reference sensor arrangement 130 comprises the reference thermal radiation emitter 131, the reference optical filter structure 132, the reference waveguide structure 133, the reference thermal radiation detector 134 on the first surface region 135-1 of the reference sensor substrate 135.

The reference cover substrate 140 comprises the reference recess 142, wherein the reference recess 142 is arranged in the first main surface region 140-1 of the reference cover substrate 140. The first main surface region 140-1 of the reference cover substrate is bonded, e.g. wafer bonded or fusion bonded on wafer-level, to the first main surface region 135-1 of the reference sensor substrate 135. The reference recess 142 in the first main surface region 140-1 forms the hermetically closed (e.g. sealed) cavity (= structured cavity) 144 for the reference sensor arrangement (reference path) 130. The reference cover substrate 140 does not comprise a through opening to the environment and constitutes therefore a hermetic cavity 144 with no exchange of fluids possible between the reference sensor cavity 144 and the environment.

According to an embodiment, the waveguide structure 113 of the sensor arrangement 110 may (optionally) comprise a first waveguide portion 113-1 and a second waveguide portion 113-2, which are optically arranged between the thermal radiation emitter 111 and the thermal radiation detector 114. Thus, the thermal radiation emitter 111 couples into the two waveguide portions 113-1, 113-2, which lead to the thermal radiation detector 114. The two waveguide portions 113-1, 113-2 may have (parallel to the reference plane) a L-shape or an arc shape, so that the two waveguide portions 113-1, 113-2 each lead to the thermal radiation detector 114.

According to the embodiment, the reference waveguide structure 133 of the reference sensor arrangement 130 may (optionally) comprise a first reference waveguide portion 133-1 and a second reference waveguide portion 133-2, which are optically arranged between the reference thermal radiation emitter 131 and the reference thermal radiation detector 144. Thus, the reference thermal radiation emitter 131 couples into the two waveguide portions 133-1, 133-2, which lead to the reference thermal radiation detector 134. The two reference waveguide portions 133 may have (parallel to the reference plane) a L-shape or an arc shape, so that the two reference waveguide portions 133 each lead to the reference thermal radiation detector 134.

According to an embodiment, the elements 111, 112, 113, 114 of the sensor arrangement 110 and the corresponding reference elements 131, 132, 133, 134 of the reference sensor arrangement 130 have the same structural setup (composition) and functionality with the exception of the through-opening(s) in the cover substrate which are not present in the reference cover substrate.

As shown in Fig. 5a, the cavity 176 is arranged in the sensor substrate 135 (i.e. in the second dielectric layer 172 and the semiconductor layer 174) vertically below the reference thermal radiation detector 134. Further, the bonding areas (bonding regions) 190 between the bonded substrates (wafers) are shown in Figs. 5a.

As further shown in Fig. 5a, the monolithic fluid sensor system 100 further comprises a bottom substrate 155 (= 150 and/or 160), wherein the second main surface region 140-2 of the reference cover substrate 140 is bonded (= wafer bonded or fusion bonded) to the second main surface region 115-2 of the sensor substrate 115, and wherein the first main surface region 155-1 of the bottom substrate 155 is bonded to the second main surface region 135-2 of the reference sensor substrate 135. Thus, the sensor substrate 115 is sandwiched between the cover substrate 120 and the reference cover substrate 140, and wherein the reference sensor substrate 135 is sandwiched between the reference cover substrate 140 and the bottom substrate 155.

As shown in exploded view of the different substrates (wafers - before the bonding process) of the monolithic fluid sensor system Fig. 5b, the different substrates and wafer, respectively may be positioned and oriented with respect to each other and, then, mechanically connected by means of wafer bonding, e.g. direct or fusion bonding. Thus, a reduced footprint can be achieved due to the (possible) stacking of the sensing system 110 and the reference sensor system 130 on wafer level via bonding.

The resulting wafer stack (of Fig. 5a) may be singulated (diced) at the dicing line DL for providing the singulated (diced) monolithic fluid sensor systems 100 having the sensor arrangement 110 and the reference sensor arrangement 130, wherein the monolithic fluid sensor system 100 can be placed in the application, for example.

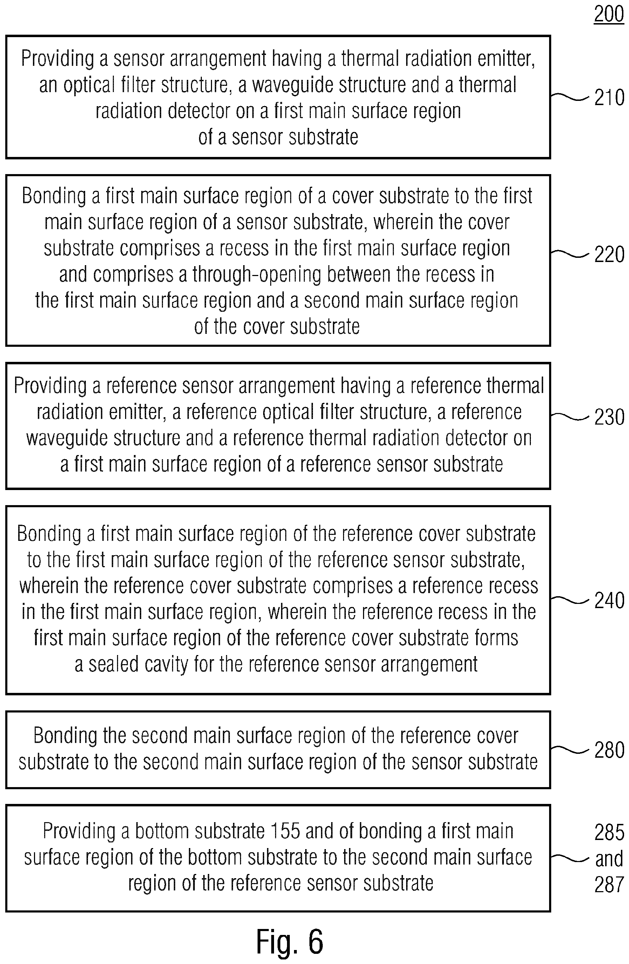

Fig. 6 shows a schematic flowchart of a further method 200 for manufacturing the monolithic fluid sensor system 100 according to a further embodiment, such as the monolithic fluid sensor system 100 of Figs. 5a-b.

The method 200 for manufacturing a monolithic fluid sensor system 100 may comprise
- the step 210 of providing a sensor arrangement 110 having a thermal radiation emitter 111, an optical filter structure 112, a waveguide structure 113 and a thermal radiation detector 114 on a first main surface region 115-1 of a sensor substrate 115,
- the step 220 of bonding, e.g. wafer or fusion bonding, a first main surface region 120-1 of a cover substrate 120, e.g. a semiconductor substrate, to the first main surface region 115-1 of a sensor substrate 115, wherein the cover substrate 120 comprises a recess 122 in the first main surface region 120-1 and comprises a through-opening 124 between the recess 122 in the first main surface region 120-1 and a second main surface region 120-2 of the cover substrate 120,
- the step 230 of providing a reference sensor arrangement 130 having a reference thermal radiation emitter 131, a reference optical filter structure 132, a reference waveguide structure 133 and a reference thermal radiation detector 134 on a first main surface region 135-1 of a reference sensor substrate 135, and
- the step 240 of bonding a first main surface region 140-1 of the reference cover substrate 140 to the first main surface region 135-1 of the reference sensor substrate 135, wherein the reference cover substrate 140 comprises a reference recess 142 in the first main surface region 140-1, wherein the reference recess 142 in the first main surface region 140-1 of the reference cover substrate 140 forms a hermetically closed (sealed) cavity 144 for the reference sensor arrangement 130.

The method 200 for manufacturing a monolithic fluid sensor system 100 may further comprise the step 280 of bonding (e.g. wafer bonding or fusion bonding) the second main surface region 140-2 of the reference cover substrate 140 to the second main surface region 115-2 of the sensor substrate 115, and the step 285 of providing a bottom substrate 155 and of bonding 287 a first main surface region 155-1 of the bottom substrate 155 to the second main surface region 135-2 of the reference sensor substrate 135.

According to an embodiment, the method steps of providing and bonding are conducted on wafer level by means of wafer bonding. To be more specific, the method steps of providing 210 the sensor arrangement 110, of bonding 220 the first main surface region of the cover substrate 120 to the first main surface region of the sensor substrate 115, of providing 230 the reference sensor arrangement 130, of bonding 240 the first main surface region of the reference cover substrate 140 to the first main surface region of the reference sensor substrate 120 and of bonding 280 the second main surface region of the reference cover substrate 140 to the second main surface region of the sensor substrate 115, and the step 285 of providing a bottom substrate 155 and bonding a first main surface region of the bottom substrate 155 to the second main surface region of the reference sensor substrate 135 are conducted on wafer level.

Thus, the sensor substrate 115 may be a sensor wafer, the cover substrate 120 may be a cover wafer, the reference sensor substrate 135 may be a reference sensor wafer, the reference cover substrate 140 may be a reference cover wafer, and the bottom substrate (spacer substrate) 155 may be a bottom wafer (spacer wafer).

The resulting wafer stack (of Fig. 5a) may be singulated (diced) at the dicing line DL for providing the singulated (diced) monolithic fluid sensor systems 100 having the sensor arrangement 110 and the reference sensor arrangement 130, wherein the monolithic fluid sensor systems 100 can be placed in the application, for example.

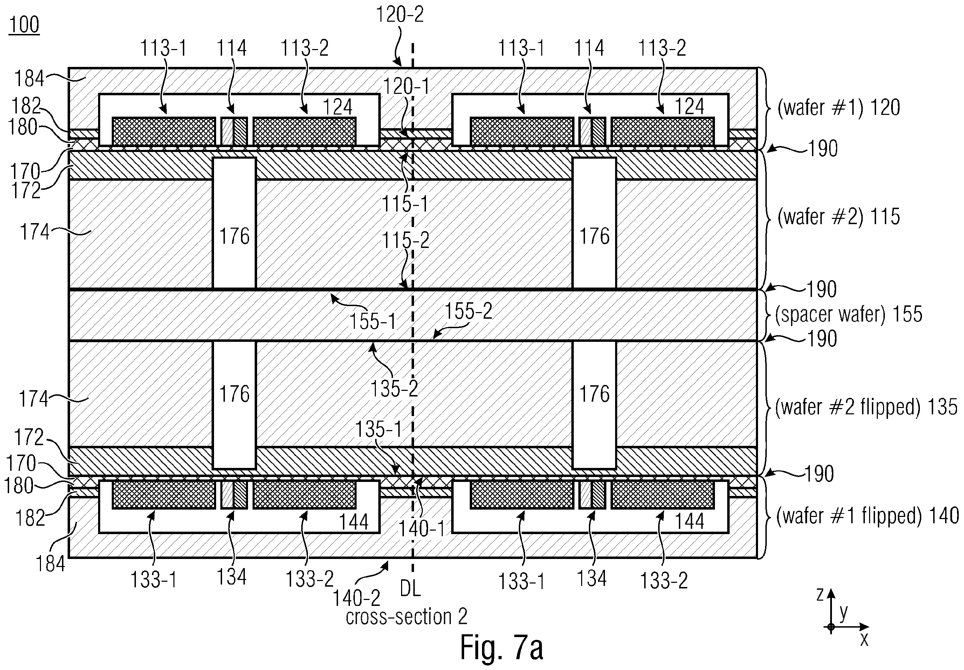

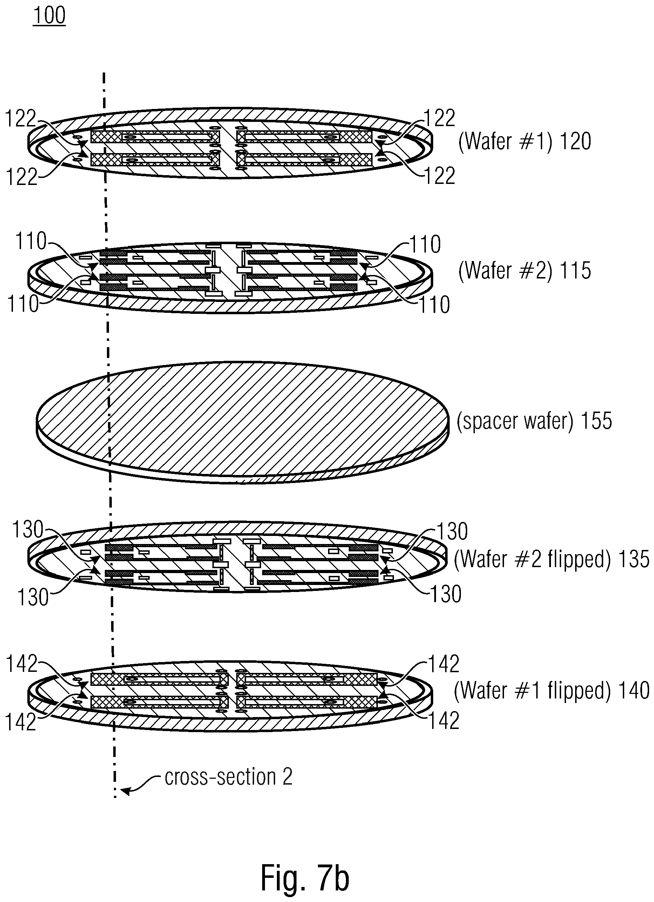

In the following, a further embodiment of the monolithic fluid sensor system 100 is described with respect to Figs. 7a-b. Figs. 7a shows a schematic cross-sectional view of the monolithic fluid sensor system 100 according to a further embodiment. Figs. 7b shows an exploded view of the different substrates (wafers - before the bonding process) of the monolithic fluid sensor system 100 according to the further embodiment.

Again referring to in Fig. 1, 2a-b and 3a-e, the monolithic fluid sensor system 100 comprises the sensor arrangement (sensor path) 110, the cover substrate 120, the reference sensor arrangement (reference path) 130, and the reference cover substrate 140. The sensor arrangement 110 comprises the thermal radiation emitter 111, the optical filter structure 112, the waveguide structure 113 and the thermal radiation detector 114 on the first main surface region 115-1 of the sensor substrate 115.

The cover substrate 120 comprises the recess, e.g. depression or hollow, 122, which is arranged in the first main surface region 120-1 of the cover substrate 120. The cover substrate 120 further comprises the through-opening, e.g. a ventilation opening or ventilation hole, 126 between the recess 122 in the first main surface region 120-1 and the second main surface region 120-2 of the cover substrate. The first main surface region 120-1 of the cover substrate 120 is bonded, e.g., wafer bonded or fusion bonded on wafer-level, to the first main surface region 115-1 of the sensor substrate 115, wherein the sensor arrangement 110 is arranged below the recess 122 of the cover substrate 120.

The recess 122 in the first main surface region 115-1 of the cover substrate 115 forms the (structured) cavity 124 for the sensor arrangement (reference path) 110, wherein the through-opening 126 forms the fluidic connection to the environment for enabling exchange of fluids between the sensor cavity 124 and the environment. The through-opening 126 in the cavity 124 of the sensor path 110 provides for an interaction (in the cavity 124) with the environmental gas.

The reference sensor arrangement 130 comprises the reference thermal radiation emitter 131, the reference optical filter structure 132, the reference waveguide structure 133, the reference thermal radiation detector 134 on the first surface region 135-1 of the reference sensor substrate 135.

The reference cover substrate 140 comprises the reference recess 142, wherein the reference recess 142 is arranged in the first main surface region 140-1 of the reference cover substrate 140. The first main surface region 140-1 of the reference cover substrate is bonded, e.g. wafer bonded or fusion bonded on wafer-level, to the first main surface region 135-1 of the reference sensor substrate 135. The reference recess 142 in the first main surface region 140-1 forms the hermetically closed (e.g. sealed) cavity (= structured cavity) 144 for the reference sensor arrangement (reference path) 130. The reference cover substrate 140 does not comprise a through opening to the environment and constitutes therefore a hermetic cavity 144 with no exchange of fluids possible between the reference sensor cavity 144 and the environment.

As shown in the monolithic fluid sensor system 100 of Figs. 7a-b, the reference sensor substrate 135 and the reference cover substrate 140 are flipped when compared to the arrangement of the reference sensor substrate 135 and the reference cover substrate 140 in the monolithic fluid sensor system 100 in Figs. 5a-b.

According to an embodiment, the waveguide structure 113 of the sensor arrangement 110 may (optionally) comprise a first waveguide portion 113-1 and a second waveguide portion 113-2, which are optically arranged between the thermal radiation emitter 111 and the thermal radiation detector 114. Thus, the thermal radiation emitter 111 couples into the two waveguide portions 113-1, 113-2, which lead to the thermal radiation detector 114. The two waveguide portions 113-1, 113-2 may have (parallel to the reference plane) a L-shape or an arc shape, so that the two waveguide portions 113-1, 113-2 each lead to the thermal radiation detector 114.

According to the embodiment, the reference waveguide structure 133 of the reference sensor arrangement 130 may (optionally) comprise a first reference waveguide portion 133-1 and a second reference waveguide portion 133-2, which are optically arranged between the reference thermal radiation emitter 131 and the reference thermal radiation detector 144. Thus, the reference thermal radiation emitter 131 couples into the two waveguide portions 133-1, 133-2, which lead to the reference thermal radiation detector 134. The two reference waveguide portions 133 may have (parallel to the reference plane) a L-shape or an arc shape, so that the two reference waveguide portions 133 each lead to the reference thermal radiation detector 134.

According to an embodiment, the elements 111, 112, 113, 114 of the sensor arrangement 110 and the corresponding reference elements 131, 132, 133, 134 of the reference sensor arrangement 130 have the same structural setup (composition) and functionality with the exception of the through-opening(s) in the cover substrate which are not present in the reference cover substrate.

As shown in Fig. 7a, the cavity 176 is arranged in the sensor substrate 135 (i.e. in the second dielectric layer 172 and the semiconductor layer 174) vertically below the reference thermal radiation detector 134.

As further shown in Fig. 7a, the monolithic fluid sensor system 100 further comprises a spacer substrate 155, wherein the first main surface region 155-1 of the spacer substrate 155 is bonded (= wafer bonded or fusion bonded) to the second main surface region 115-2 of the sensor substrate 115, and wherein the second main surface region 155-2 of the spacer substrate 155 is bonded (= wafer bonded or fusion bonded) to the second main surface region 135-2 of the reference sensor substrate 135.

Thus, the spacer substrate 155 is sandwiched between the sensor substrate 115 and the reference sensor substrate 135, wherein the sensor substrate 115 is sandwiched between the spacer substrate 155 and the cover substrate 120, and wherein the reference sensor substrate 135 is sandwiched between the spacer substrate 155 and the reference cover substrate 140.

As shown in exploded view of the different substrates (wafers - before the bonding process) of the monolithic fluid sensor system Fig. 7b, the different substrates and wafer, respectively may be positioned and oriented with respect to each other and, then, mechanically connected by means of wafer bonding, e.g. direct or fusion bonding. Thus, a reduced footprint can be achieved due to the (possible) stacking of the sensing system 110 and the reference sensor system 130 on wafer level via bonding.

Thus, the sensor substrate 115 may be a sensor wafer, the cover substrate 120 may be a cover wafer, the reference sensor substrate 135 may be a reference sensor wafer, the reference cover substrate 140 may be a reference cover wafer, and the spacer substrate 155 may be a spacer wafer.

The resulting wafer stack (of Fig. 7a) may be singulated (diced) at the dicing line DL for providing the singulated (diced) monolithic fluid sensor systems 100 having the sensor arrangement 110 and the reference sensor arrangement 130, wherein the monolithic fluid sensor systems 100 can be placed in the application, for example.

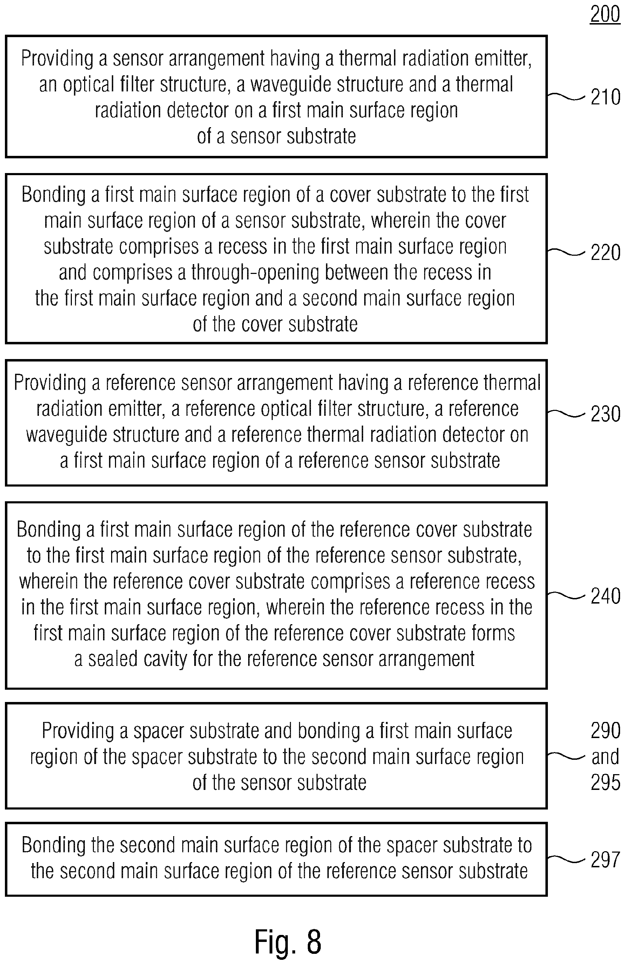

Fig. 8 shows a schematic flowchart of a further method 200 for manufacturing the monolithic fluid sensor system 100 according to a further embodiment, such as the monolithic fluid sensor system 100 of Figs. 7a-b.

The method 200 for manufacturing a monolithic fluid sensor system 100 may comprise:
- the step 210 of providing a sensor arrangement 110 having a thermal radiation emitter 111, an optical filter structure 112, a waveguide structure 113 and a thermal radiation detector 114 on a first main surface region 115-1 of a sensor substrate 115,
- the step 220 of bonding, e.g. wafer or fusion bonding, a first main surface region 120-1 of a cover substrate 120, e.g. a semiconductor substrate, to the first main surface region 115-1 of a sensor substrate 115, wherein the cover substrate 120 comprises a recess 122 in the first main surface region 120-1 and comprises a through-opening 124 between the recess 122 in the first main surface region 120-1 and a second main surface region 120-2 of the cover substrate 120,

- the step 230 of providing a reference sensor arrangement 130 having a reference thermal radiation emitter 131, a reference optical filter structure 132, a reference waveguide structure 133 and a reference thermal radiation detector 134 on a first main surface region 135-1 of a reference sensor substrate 135, and
- the step 240 of bonding a first main surface region 140-1 of the reference cover substrate 140 to the first main surface region 135-1 of the reference sensor substrate 135, wherein the reference cover substrate 140 comprises a reference recess 142 in the first main surface region 140-1, wherein the reference recess 142 in the first main surface region 140-1 of the reference cover substrate 140 forms a hermetically closed (sealed) cavity 144 for the reference sensor arrangement 130.

The method 200 for manufacturing a monolithic fluid sensor system 100 may further comprise the step 290 of providing a spacer substrate 155 and bonding 295 a first main surface region 155-1 of the spacer substrate 155 to the second main surface region 115-2 of the sensor substrate 115, and the step 297 of bonding the second main surface region 155-2 of the spacer substrate 155 to the second main surface region 135-2 of the reference sensor substrate 135.

According to an embodiment, the method steps of providing and bonding are conducted on wafer level by means of wafer bonding. Thus, the sensor substrate 115 may be a sensor wafer, the cover substrate 120 may be a cover wafer, the reference sensor substrate 135 may be a reference sensor wafer, the reference cover substrate 140 may be a reference cover wafer, and the bottom substrate 155 may be bottom wafer.

The resulting wafer stack (of Fig. 7a) may be singulated (diced) at the dicing line DL for providing the singulated (diced) monolithic fluid sensor systems 100 having the sensor arrangement 110 and the reference sensor arrangement 130, wherein the monolithic fluid sensor systems 100 can be placed in the application, for example.

In the following, embodiments and technical aspects of the present disclosure are described and summarized which may be used alone or in combination with the features and functionalities described herein.

Embodiments of the present disclosure relate in general to the field of monolithic fluid sensor systems 100 and methods 200 for manufacturing such monolithic fluid sensor systems. In particular, embodiments relate to a fusion-bond or wafer-bond based wafer-level package for a mid-infrared gas sensor system 100.

The monolithic fluid sensor system 100 uses (for the sensor path 110 and the reference path 130): a thermal emitter 111, 131 having a narrow-band wavelength filter 112, 132 integrated in a waveguide 113, 133, said waveguide and a detector 114, 134, e.g. pyro detector or alternatively a piezo or thermal diode-based detector. The waveguide 113, 133 serves for guiding the emitted radiation and having it interact with the environment. The result is a specific absorption of the radiation, which subsequently allows detecting a target gas concentration, e.g. the CO₂ concentration, in the ambient air by means of spectroscopy, for example.

In summary, radiation is coupled into an optical waveguide 113, 133 and filtered. For determining a CO₂ concentration, a narrow-band filtering of the wavelengths in the waveguide 113, 133 around a wavelength of 4.26 µm is provided, which corresponds to the absorption of CO2 in air. In order for this wavelength region to be emitted at a sufficiently strong power, an emitter temperature of about 600°C-800°C is set.

The monolithic fluid sensor system 100 ensures a very high efficiency of the power transmission, or intensity at which waves in the filtered wavelength region are provided, emanating from the thermal emitter 111, 131. This is achieved even if (already) "small" influences, like impure filter structures or defects at the waveguide 113, 133, may result in a coupling loss. Since a waveguide 113, 133 has the characteristic of directing the radiation along its path, the radiation introduced can be guided specifically by its shape, which offers the possibility of not only increasing the intensity at which the radiation impinges on the detector 114, 134, but also ensuring the most efficient usage of a single black (or full) radiator (thermal emitter) as the radiation source 111, 131, and a more effective usage of the electrical power to be provided for the radiator.

By making use of the waveguide characteristic mentioned, a reference measurement can be conducted at the same time, without abandoning optimization of the transmission intensity. A reference measurement would support signal evaluation when measuring individual gas concentrations (background noise is taken into consideration).

Based on the monolithic fluid sensor system 100, it can be shown that both the requirements to a reference measurement (i.e. the reference and actual measurements have an equal behavior when external influences change, variations of the input voltage, for example at the emitter, should apply to both to the same extent), and also an increase in the intensity of the transmission of radiation from the emitter to the detector can be realized within a single overall system, i.e. the monolithic fluid sensor system 100.

The emitter(s) 111, 131 couples into four waveguides 113-1, 113-2 and 133-1, 133-2 (= two pairs of waveguides 113, 133) which lead to two detectors 114, 134. The four waveguides are formed in an L-shape or arc shape, for example, meaning that two waveguides each lead to one detector. The scheme of the waveguides can be varied in different variations (e.g. slab, strip, slot, etc.).

In the monolithic fluid sensor system 100, one detector 134 serves as a reference, a further detector 114 for measuring the ambient gas. The reference path 130 on a Si wafer 135 is prevented from interacting with the environment by means of a silicon cover 140. Both the Si wafer 135 and the Si cover wafer 140 of the reference path 130 as well as the Si wafer 115 and the Si cover wafer 120 of the sensing path 110 comprise a passivation against potential absorption of the basic material substrate from SiO₂ and Si₃N₄. These layers 170, 172 and 180, 182 are also present as a top layer of the bonding areas 190, thereby selecting the bond method to be fusion bonding, for example. Fusion bonding allows a pure wafer bond in the case of SiO₂-SiO₂ and Si₃N₄- Si₃N₄, as long as, in the case of a nitride layer, its thickness is between 100 and 200nm (resulting in a design rule).

The detectors 114, 134 are supported on membranes (= dielectric layers 170, 172), e.g. formed of Si₃N₄, meaning that they are exposed by means of a "bosch" etching in order to thermally insulate the same from the substrate 174 and the contact pads (the same applies for the emitter).

In order to produce hermetic bonding, the electrically conductive contacts 111-#, 131-# and 114-#, 134-# to the emitter 111, 131 and the detector 114, 134 are at least partly buried, i.e. comprise buried conductors. In order to provide for a complete wafer-level package, the bottom of the Si wafer "supporting the system" may be terminated by means of a Si bottom wafer or spacer wafer 155.

In the monolithic fluid sensor system 100, the described approach of arranging the waveguides 113, 133 is aimed to achieve the best possible utilization of the solid angle of radiation and the surface of the emitter 111, 131. Thus, the monolithic fluid sensor system 100 allows to make use of the radiation of the emitter 111, 131 in the lateral direction. Additionally, using a "true" reference path 130 would save algorithms for interpreting measuring results to a certain extent.

The monolithic fluid sensor system 100 provides an efficient utilization of the emitter radiation, which supports the monolithic approach based on a thermal emitter 111, 131 in connection with waveguides 113, 133. Even if the utilization of waveguides may entail coupling losses (which is a known effect). The utilization of two (parallel) waveguides 113-1, 113-2 and 133-1, 133-2 in the sensor path 110 and the reference path 130, which are each guided to a respective detector 114, 134 results in an increase in the area for interaction with the fluid (= gas or liquid) to be sampled. The detector 114, 134 takes advantage from being heated from both sides.

Such an approach synergistically combines the following exemplary aspects:
- High energy efficiency: most efficient utilization possible of the emitted radiation
- form factor: the two-times double waveguide 113, 133 concept offers high interaction between radiation and gas on a comparatively small area
- Highly sensitive: an improved resolution can be obtained by more radiation power impinging on the detector 114, 134
- Monolithic sensor system 100
- Reference path 130: realized by means of a (e.g. Si) wafer bond in the form of a concept which allows both interaction with the ambient gas (in the sensor arrangement) and forming cavities 144 for the reference sensor arrangement 130, and which integrates a shielding which protects from wave absorption by the (e.g. Si) cover 140.

The monolithic fluid sensor system 100 can implemented as a single chip or a package. The hermitic sealing of the bond regions and the cavities can be achieved by means of wafer bonding the respective wafer (substrates) at the dedicated bonding regions 190.

Additional embodiments and aspects are described which may be used alone or in combination with the features and functionalities described herein.

According to an embodiment, the monolithic fluid sensor system 100 comprises a sensor arrangement 110 having a thermal radiation emitter 111, an optical filter structure 112, a waveguide structure 113 and a thermal radiation detector 114 on a first main surface region of a sensor substrate 115, a cover substrate 120, wherein a recess 122 is arranged in a first main surface region of the cover substrate 120 and a through-opening 126 is arranged between the recess 122 in the first main surface region and a second main surface region of the cover substrate 120, wherein the first main surface region of the cover substrate 120 is bonded to the first main surface region of a sensor substrate 115; 105, and wherein the sensor arrangement 110 is arranged below the recess 122 of the cover substrate 120, a reference sensor arrangement 130 having a reference thermal radiation emitter 131, a reference optical filter structure 132, a reference waveguide structure 133 and a reference thermal radiation detector 134 on a first main surface region of a reference sensor substrate 135, and a reference cover substrate 140, wherein a reference recess 142 is arranged in a first main surface region of the reference cover substrate 140, wherein the first main surface region of the reference cover substrate 140 is bonded to the first main surface region of the reference sensor substrate 135, and wherein the reference recess 142 in the first main surface region of the reference cover substrate 140 forms a hermetically closed cavity 144 for the reference sensor arrangement 130.

According to an embodiment, the elements of the sensor arrangement 110 and the reference elements of the reference sensor arrangement 130 have the same structural setup.

According to an embodiment, the monolithic fluid sensor system 100 further comprises a bottom substrate 150; 155, wherein a first main surface region of the bottom substrate 150; 155 is bonded to the second main surface region of the sensor substrate 115, and a reference bottom substrate 160; 155, wherein a first main surface region of the reference bottom substrate 160; 155 is bonded to the second main surface region of the reference sensor substrate 135.

According to an embodiment, the sensor substrate 115 and the reference sensor substrate 135 are arranged to form a common system substrate 105, wherein the cover substrate 120 and the reference cover substrate 140 are arranged to form a common cover substrate 145, and wherein the bottom substrate 150 and the reference bottom substrate 160 are arranged to form a common bottom substrate 155.

According to an embodiment, the sensor substrate 115 and the reference sensor substrate 135 are arranged to form separate system substrates, wherein the cover substrate 120 and the reference cover substrate 140 are arranged to form separate cover substrates, and wherein the bottom substrate 150 and the reference bottom substrate 160 are arranged to form separate bottom substrates.

According to an embodiment, the monolithic fluid sensor system 100 further comprises a bottom substrate 155, wherein the second main surface region of the reference cover substrate 120 is bonded to the second main surface region of the sensor substrate 115, and wherein the first main surface region of the bottom substrate 155 is bonded to the second main surface region of the reference sensor substrate 135.

According to an embodiment, the monolithic fluid sensor system 100 further comprises a spacer substrate 155, wherein the first main surface region of the spacer substrate 155 is bonded to the second main surface region of the sensor substrate 115, and wherein the second main surface region of the spacer substrate 155 is bonded to the second main surface region of the reference sensor substrate 135. The first main surface region of the cover substrate 120 is bonded to the first main surface region of a sensor substrate 115, and the first main surface region of the reference cover substrate 140 is bonded to the first main surface region of the reference sensor substrate 135.

According to an embodiment, a method 200 for manufacturing a monolithic fluid sensor system 100 comprises providing 210 a sensor arrangement having a thermal radiation emitter, an optical filter structure, a waveguide structure and a thermal radiation detector on a first main surface region of a sensor substrate, bonding 220 a first main surface region of a cover substrate to the first main surface region of a sensor substrate, wherein the cover substrate comprises a recess in the first main surface region and comprises a through-opening between the recess in the first main surface region and a second main surface region of the cover substrate, providing 230 a reference sensor arrangement having a reference thermal radiation emitter, a reference optical filter structure, a reference waveguide structure and a reference thermal radiation detector on a first main surface region of a reference sensor substrate, and bonding 240 a first main surface region of the reference cover substrate to the first main surface region of the reference sensor substrate, wherein the reference cover substrate comprises a reference recess in the first main surface region, wherein the reference recess in the first main surface region of the reference cover substrate forms a sealed cavity for the reference sensor arrangement.

According to an embodiment, the method steps (-) of providing 210 a sensor arrangement, (-) of bonding 220 a first main surface region of a cover substrate to the first main surface region of a sensor substrate, (-) of providing 230 a reference sensor arrangement, and (-) of bonding 240 a first main surface region of the reference cover substrate to the first main surface region of the reference sensor substrate are conducted on wafer level.

According to an embodiment, the method 200 further comprises the steps of providing 250 a bottom substrate and bonding a first main surface region of the bottom substrate to the second main surface region of the sensor substrate, and Providing 260 a reference bottom substrate and bonding 265 a first main surface region of the reference bottom substrate to the second main surface region of the reference sensor substrate.

According to an embodiment, the sensor substrate and the reference sensor substrate are arranged to form a common system substrate, wherein the cover substrate and the reference cover substrate are arranged to form a common cover substrate, and wherein the bottom substrate and the reference bottom substrate are arranged to form a common bottom substrate, wherein the method 200 further comprises conducting 270 the steps of providing a bottom substrate and bonding and the steps of providing a reference bottom substrate and bonding on wafer level.

According to an embodiment, the sensor substrate and the reference sensor substrate are arranged to form separate system substrates, wherein the cover substrate and the reference cover substrate are arranged to form separate cover substrates, and wherein the bottom substrate and the reference bottom substrate are arranged to form separate bottom substrates.

According to an embodiment the method 200 further comprises bonding 280 the second main surface region of the reference cover substrate to the second main surface region of the sensor substrate, and providing 285 a bottom substrate and bonding 287 a first main surface region of the bottom substrate to the second main surface region of the reference sensor substrate.

According to an embodiment the method 200 further comprises providing 290 a spacer substrate and bonding 295 a first main surface region of the spacer substrate to the second main surface region of the sensor substrate, and bonding 297 the second main surface region of the spacer substrate to the second main surface region of the reference sensor substrate.

According to an embodiment the method steps of bonding are conducted on wafer level by means of wafer bonding.

Although some aspects have been described as features in the context of an apparatus it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of the control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may for example be stored on a machine readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

## Claims

1. Monolithic fluid sensor system (100) for sensing a fluid in the environment, comprising:
a sensor arrangement (110) having a thermal radiation emitter (111), an optical filter structure (112), a waveguide structure (113) and a thermal radiation detector (114) on a first main surface region (115-1) of a sensor substrate (115) a cover substrate (120), wherein a recess (122) is arranged in a first main surface region (120-1) of the cover substrate (120) and a through-opening (126) is arranged between the recess (122) in the first main surface region (120-1) and a second main surface region (120-2) of the cover substrate (120), wherein the first main surface region (120-1) of the cover substrate (120) is bonded to the first main surface region (115-1) of the sensor substrate (115; 105), and wherein the sensor arrangement (110) is arranged below the recess (122) of the cover substrate (120),
wherein the recess (122) forms a cavity (124) and wherein the through-opening (126) forms a fluidic connection from the cavity to the environment,
a reference sensor arrangement (130) having a reference thermal radiation emitter (131), a reference optical filter structure (132), a reference waveguide structure (133) and a reference thermal radiation detector (134) on a first main surface region (135-1) of a reference sensor substrate (135), and
a reference cover substrate (140), wherein a reference recess (142) is arranged in a first main surface region (140-1) of the reference cover substrate (140), wherein the first main surface region (140-1) of the reference cover substrate (140) is bonded to the first main surface region (135-1) of the reference sensor substrate (135), and wherein the reference recess (142) in the first main surface region (140-1) of the reference cover substrate (140) forms a hermetically closed cavity (144) for the reference sensor arrangement (130).

2. The monolithic fluid sensor system (100) of claim 1, wherein the elements of the sensor arrangement (110) and the reference elements of the reference sensor arrangement (130) have the same structural setup.

3. The monolithic fluid sensor system (100) of claim 1 or 2, further comprising:
a bottom substrate (150), wherein a first main surface region (150-1) of the bottom substrate (150) is bonded to the second main surface region (115-2) of the sensor substrate (115), and
a reference bottom substrate (160), wherein a first main surface region (160-1) of the reference bottom substrate (160) is bonded to the second main surface region (135-2) of the reference sensor substrate (135).

4. The monolithic fluid sensor system (100) of any of the preceding claims, wherein the sensor substrate (115) and the reference sensor substrate (135) are arranged to form a common system substrate (105), wherein the cover substrate (120) and the reference cover substrate (140) are arranged to form a common cover substrate (145), and wherein the bottom substrate (150) and the reference bottom substrate (160) are arranged to form a common bottom substrate (155).

5. The monolithic fluid sensor system (100) of any of claims 1 to 3, wherein the sensor substrate (115) and the reference sensor substrate (135) are arranged to form separate system substrates, wherein the cover substrate (120) and the reference cover substrate (140) are arranged to form separate cover substrates, and wherein the bottom substrate (150) and the reference bottom substrate (160) are arranged to form separate bottom substrates.

6. The monolithic fluid sensor system (100) of claim 1 or 2, further comprising:
a bottom substrate (155),
wherein the second main surface region (140-2) of the reference cover substrate (140) is bonded to the second main surface region (115-2) of the sensor substrate (115), and
wherein the first main surface region (155-1) of the bottom substrate (155) is bonded to the second main surface region (135-2) of the reference sensor substrate (135), so that the sensor substrate (115) is sandwiched between the cover substrate (120) and the reference cover substrate (140).

7. The monolithic fluid sensor system (100) of claim 1 or 2, further comprising:
a spacer substrate (155), wherein the first main surface region (155-1) of the spacer substrate (155) is bonded to the second main surface region (115-2) of the sensor substrate (115), and
wherein the second main surface region (155-2) of the spacer substrate (155) is bonded to the second main surface region (135-2) of the reference sensor substrate (135), so that the spacer substrate (155) is sandwiched between the sensor substrate (115) and the reference sensor substrate (135).

8. Method (200) for manufacturing a monolithic fluid sensor system (100), comprising:
providing (210) a sensor arrangement having a thermal radiation emitter, an optical filter structure, a waveguide structure and a thermal radiation detector on a first main surface region of a sensor substrate,
bonding (220) a first main surface region of a cover substrate to the first main surface region of a sensor substrate, wherein the cover substrate comprises a recess in the first main surface region and comprises a through-opening between the recess in the first main surface region and a second main surface region of the cover substrate,
wherein the recess forms a cavity and wherein the through-opening forms a fluidic connection from the cavity to the environment, providing (230) a reference sensor arrangement having a reference thermal radiation emitter, a reference optical filter structure, a reference waveguide structure and a reference thermal radiation detector on a first main surface region of a reference sensor substrate, and
bonding (240) a first main surface region of the reference cover substrate to the first main surface region of the reference sensor substrate, wherein the reference cover substrate comprises a reference recess in the first main surface region, wherein the reference recess in the first main surface region of the reference cover substrate forms a sealed cavity for the reference sensor arrangement.

9. The method (200) of claim 8, wherein the method steps of providing (210) a sensor arrangement, of bonding (220) a first main surface region of a cover substrate to the first main surface region of a sensor substrate, of providing (230) a reference sensor arrangement, and of bonding (240) a first main surface region of the reference cover substrate to the first main surface region of the reference sensor substrate are conducted on wafer level.

10. The method (200) of claim 8 or 9, further comprising:
Providing (250) a bottom substrate and bonding a first main surface region of the bottom substrate to the second main surface region of the sensor substrate, and
Providing (260) a reference bottom substrate and bonding (265) a first main surface region of the reference bottom substrate to the second main surface region of the reference sensor substrate.

11. The method (200) of claim 10, wherein the sensor substrate and the reference sensor substrate are arranged to form a common system substrate, wherein the cover substrate and the reference cover substrate are arranged to form a common cover substrate, and wherein the bottom substrate and the reference bottom substrate are arranged to form a common bottom substrate, further comprising:
Conducting (270) the steps of providing a bottom substrate and bonding and the steps of providing a reference bottom substrate and bonding on wafer level.

12. The method (200) of claim 10, wherein the sensor substrate and the reference sensor substrate are arranged to form separate system substrates, wherein the cover substrate and the reference cover substrate are arranged to form separate cover substrates, and wherein the bottom substrate and the reference bottom substrate are arranged to form separate bottom substrates.

13. The method (200) of claim 8 or 9, further comprising
bonding (280) the second main surface region of the reference cover substrate to the second main surface region of the sensor substrate, and
providing (285) a bottom substrate and bonding (287) a first main surface region of the bottom substrate to the second main surface region of the reference sensor substrate.

14. The method (200) of claim 8 or 9, further comprising
Providing (290) a spacer substrate and bonding (295) a first main surface region of the spacer substrate to the second main surface region of the sensor substrate, and bonding (297) the second main surface region of the spacer substrate to the second main surface region of the reference sensor substrate.

15. The method (200) of any of claims 10 to 14, wherein the method steps of bonding are conducted on wafer level by means of wafer bonding.

## Patentansprüche

1. Monolithisches Fluidsensorsystem (100) zum Erfassen eines Fluids in der Umgebung, das folgende Merkmale aufweist:
eine Sensoranordnung (110), die einen Wärmestrahlungsemitter (111), eine optische Filterstruktur (112), eine Wellenleiterstruktur (113) und einen Wärmestrahlungsdetektor (114) auf einer ersten Hauptoberflächenregion (115-1) eines Sensorsubstrats (115) aufweist;
ein Abdecksubstrat (120), wobei eine Ausnehmung (122) in einer ersten Hauptoberflächenregion (120-1) des Abdecksubstrats (120) angeordnet ist und eine Durchgangsöffnung (126) zwischen der Ausnehmung (122) in der ersten Hauptoberflächenregion (120-1) und einer zweiten Hauptoberflächenregion (120-2) des Abdecksubstrats (120) angeordnet ist, wobei die erste Hauptoberflächenregion (120-1) des Abdecksubstrats (120) an die erste Hauptoberflächenregion (115-1) des Sensorsubstrats (115; 105) gebunden ist, und wobei die Sensoranordnung (110) unterhalb der Ausnehmung (122) des Abdecksubstrats (120) angeordnet ist;
wobei die Ausnehmung (122) einen Hohlraum (124) bildet und wobei die Durchgangsöffnung (126) eine fluidische Verbindung von dem Hohlraum zu der Umgebung bildet,
eine Referenzsensoranordnung (130), die einen Referenzwärmestrahlungsemitter (131), eine optische Referenzfilterstruktur (132), eine Referenzwellenleiterstruktur (133) und einen Referenzwärmestrahlungsdetektor (134) auf einer ersten Hauptoberflächenregion (135-1) eines Referenzsensorsubstrats (135) aufweist, und
ein Referenzabdecksubstrat (140), wobei eine Referenzausnehmung (142) in einer ersten Hauptoberflächenregion (140-1) des Referenzabdecksubstrats (140) angeordnet ist, wobei die erste Hauptoberflächenregion (140-1) des Referenzabdecksubstrats (140) an die erste Hauptoberflächenregion (135-1) des Referenzsensorsubstrats (135) gebunden ist, und wobei die Referenzausnehmung (142) in der ersten Hauptoberflächenregion (140-1) des Referenzabdecksubstrats (140) einen hermetisch geschlossenen Hohlraum (144) für die Referenzsensoranordnung (130) bildet.

2. Das monolithische Fluidsensorsystem (100) gemäß Anspruch 1, bei dem die Elemente der Sensoranordnung (110) und die Referenzelemente der Referenzsensoranordnung (130) den gleichen Strukturaufbau aufweisen.

3. Das monolithisches Fluidsensorsystem (100) gemäß Anspruch 1 oder 2, das ferner folgende Merkmale aufweist:
ein Bodensubstrat (150), wobei eine erste Hauptoberflächenregion (150-1) des Bodensubstrats (150) an die zweite Hauptoberflächenregion (115-2) des Sensorsubstrats (115) gebunden ist, und
ein Referenzbodensubstrat (160), wobei eine erste Hauptoberflächenregion (160-1) des Referenzbodensubstrats (160) an die zweite Hauptoberflächenregion (135-2) des Referenzsensorsubstrats (135) gebunden ist.

4. Das monolithische Fluidsensorsystem (100) gemäß einem der vorherigen Ansprüche, bei dem das Sensorsubstrat (115) und das Referenzsensorsubstrat (135) angeordnet sind, um ein gemeinsames Systemsubstrat (105) zu bilden, wobei das Abdecksubstrat (120) und das Referenzabdecksubstrat (140) angeordnet sind, um ein gemeinsames Abdecksubstrat (145) zu bilden, und wobei das Bodensubstrat (150) und das Referenzbodensubstrat (160) angeordnet sind, um ein gemeinsames Bodensubstrat (155) zu bilden.

5. Das monolithische Fluidsensorsystem (100) gemäß einem der Ansprüche 1 bis 3, bei dem das Sensorsubstrat (115) und das Referenzsensorsubstrat (135) angeordnet sind, um separate Systemsubstrate zu bilden, wobei das Abdecksubstrat (120) und das Referenzabdecksubstrat (140) angeordnet sind, um separate Abdecksubstrate zu bilden, und wobei das Bodensubstrat (150) und das Referenzbodensubstrat (160) angeordnet sind, um separate Bodensubstrate zu bilden.

6. Das monolithische Fluidsensorsystem (100) gemäß Anspruch 1 oder 2, das ferner folgendes Merkmal aufweist:
ein Bodensubstrat (155),
wobei die zweite Hauptoberflächenregion (140-2) des Referenzabdecksubstrats (140) an die zweite Hauptoberflächenregion (115-2) des Sensorsubstrats (115) gebunden ist, und
wobei die erste Hauptoberflächenregion (155-1) des Bodensubstrats (155) an die zweite Hauptoberflächenregion (135-2) des Referenzsensorsubstrats (135) gebunden ist, so dass das Sensorsubstrat (115) sandwichartig zwischen dem Abdecksubstrat (120) und dem Referenzabdecksubstrat (140) angeordnet ist.

7. Das monolithische Fluidsensorsystem (100) gemäß Anspruch 1 oder 2, das ferner folgendes Merkmal aufweist:
ein Abstandshaltersubstrat (155), wobei die erste Hauptoberflächenregion (155-1) des Abstandshaltersubstrats (155) an die zweite Hauptoberflächenregion (115-2) des Sensorsubstrats (115) gebunden ist, und
wobei die zweite Hauptoberflächenregion (155-2) des Abstandshaltersubstrats (155) an die zweite Hauptoberflächenregion (135-2) des Referenzsensorsubstrats (135) gebunden ist, so dass das Abstandshaltersubstrat (155) sandwichartig zwischen dem Sensorsubstrat (115) und dem Referenzsensorsubstrat (135) angeordnet ist.

8. Verfahren (200) zum Herstellen eines monolithischen Fluidsensorsystems (100), das folgende Schritte aufweist:
Bereitstellen (210) einer Sensoranordnung, die einen Wärmestrahlungsemitter, eine optische Filterstruktur, eine Wellenleiterstruktur und einen Wärmestrahlungsdetektor auf einer ersten Hauptoberflächenregion eines Sensorsubstrats aufweist,
Binden (220) einer ersten Hauptoberflächenregion eines Abdecksubstrats an die erste Hauptoberflächenregion eines Sensorsubstrats, wobei das Abdecksubstrat eine Ausnehmung in der ersten Hauptoberflächenregion aufweist und eine Durchgangsöffnung zwischen der Ausnehmung in der ersten Hauptoberflächenregion und einer zweiten Hauptoberflächenregion des Abdecksubstrats aufweist,
wobei die Ausnehmung einen Hohlraum bildet und wobei die Durchgangsöffnung eine fluidische Verbindung von dem Hohlraum zu der Umgebung bildet,
Bereitstellen (230) einer Referenzsensoranordnung, die einen Referenzwärmestrahlungsemitter, eine optische Referenzfilterstruktur, eine Referenzwellenleiterstruktur und einen Referenzwärmestrahlungsdetektor auf einer ersten Hauptoberflächenregion eines Referenzsensorsubstrats aufweist, und
Binden (240) einer ersten Hauptoberflächenregion des Referenzabdecksubstrats an die erste Hauptoberflächenregion des Referenzsensorsubstrats, wobei das Referenzabdecksubstrat eine Referenzausnehmung in der ersten Hauptoberflächenregion aufweist, wobei die Referenzausnehmung in der ersten Hauptoberflächenregion des Referenzabdecksubstrats einen abgedichteten Hohlraum für die Referenzsensoranordnung bildet.

9. Das Verfahren (200) gemäß Anspruch 8, bei dem die Verfahrensschritte des Bereitstellens (210) einer Sensoranordnung, des Bindens (220) einer ersten Hauptoberflächenregion eines Abdecksubstrats an die erste Hauptoberflächenregion eines Sensorsubstrats, des Bereitstellens (230) einer Referenzsensoranordnung und des Bindens (240) einer ersten Hauptoberflächenregion des Referenzabdecksubstrats an die erste Hauptoberflächenregion des Referenzsensorsubstrats auf Waferebene ausgeführt werden.

10. Das Verfahren (200) gemäß Anspruch 8 oder 9, das ferner folgende Schritte aufweist:
Bereitstellen (250) eines Bodensubstrats und Binden einer ersten Hauptoberflächenregion des Bodensubstrats an die zweite Hauptoberflächenregion des Sensorsubstrats, und
Bereitstellen (260) eines Referenzbodensubstrats und Binden (265) einer ersten Hauptoberflächenregion des Referenzbodensubstrats an die zweite Hauptoberflächenregion des Referenzsensorsubstrats.

11. Das Verfahren (200) gemäß Anspruch 10, bei dem das Sensorsubstrat und das Referenzsensorsubstrat angeordnet sind, um ein gemeinsames Systemsubstrat zu bilden, wobei das Abdecksubstrat und das Referenzabdecksubstrat angeordnet sind, um ein gemeinsames Abdecksubstrat zu bilden, und wobei das Bodensubstrat und das Referenzbodensubstrat angeordnet sind, um ein gemeinsames Bodensubstrat zu bilden, das ferner folgenden Schritt aufweist:
Ausführen (270) der Schritte des Bereitstellens eines Bodensubstrats und Bindens und der Schritte des Bereitstellens eines Referenzbodensubstrats und Bindens auf Waferebene.

12. Das Verfahren (200) gemäß Anspruch 10, bei dem das Sensorsubstrat und das Referenzsensorsubstrat angeordnet sind, um separate Systemsubstrate zu bilden, wobei das Abdecksubstrat und das Referenzabdecksubstrat angeordnet sind, um separate Abdecksubstrate zu bilden, und wobei das Bodensubstrat und das Referenzbodensubstrat angeordnet sind, um separate Bodensubstrate zu bilden.

13. Das Verfahren (200) gemäß Anspruch 8 oder 9, das ferner folgende Schritte aufweist:
Binden (280) der zweiten Hauptoberflächenregion des Referenzabdecksubstrats an die zweite Hauptoberflächenregion des Sensorsubstrats und
Bereitstellen (285) eines Bodensubstrats und Binden (287) einer ersten Hauptoberflächenregion des Bodensubstrats an die zweite Hauptoberflächenregion des Referenzsensorsubstrats.

14. Das Verfahren (200) gemäß Anspruch 8 oder 9, das ferner folgende Schritte aufweist:
Bereitstellen (290) eines Abstandshaltersubstrats und Binden (295) einer ersten Hauptoberflächenregion des Abstandshaltersubstrats an die zweite Hauptoberflächenregion des Sensorsubstrats und
Binden (297) der zweiten Hauptoberflächenregion des Abstandshaltersubstrats an die zweite Hauptoberflächenregion des Referenzsensorsubstrats.

15. Das Verfahren gemäß einem der Ansprüche 10 bis 14, bei dem die Verfahrensschritte des Bindens auf Waferebene mittels Waferbonden ausgeführt werden.

## Revendications

1. Système (100) de capteur de fluide monolithique pour détecter un fluide dans l'environnement, comportant :
un agencement (110) de capteur ayant un émetteur (111) de rayonnement thermique, une structure (112) de filtre optique, une structure (113) de guide d'ondes et un détecteur (114) de rayonnement thermique sur une première région (115-1) de surface principale d'un substrat (115) de capteur,
un substrat (120) de recouvrement, dans lequel un évidement (122) est ménagé dans une première région (120-1) de surface principale du substrat (120) de recouvrement et une ouverture (126) traversante est ménagée entre l'évidement (122) dans la première région (120-1) de surface principale et une deuxième région (120-2) de surface principale du substrat (120) de recouvrement, dans lequel la première région (120-1) de surface principale du substrat (120) de recouvrement est liée à la première région (115-1) de surface principale du substrat (115 ; 105) de capteur, et dans lequel l'agencement (110) de capteur est agencé en-dessous de l'évidement (122) du substrat (120) de recouvrement,
dans lequel l'évidement (122) forme une cavité (124) et dans lequel l'ouverture (126) traversante forme une connexion pour les fluides de la cavité vers l'environnement,
un agencement (130) de capteur de référence ayant un émetteur (131) de rayonnement thermique de référence, une structure (132) de filtre optique de référence, une structure (133) de guide d'ondes de référence et un détecteur (134) de rayonnement thermique de référence sur une première région (135-1) de surface principale d'un substrat (135) de capteur de référence, et
un substrat (140) de recouvrement de référence, dans lequel un évidement (142) de référence est ménagé dans une première région (140-1) de surface principale du substrat (140) de recouvrement de référence, dans lequel la première région (140-1) de surface principale du substrat (140) de recouvrement de référence est liée à la première région (135-1) de surface principale du substrat (135) de capteur de référence, et dans lequel l'évidement (142) de référence dans la première région (140-1) de surface principale du substrat (140) de recouvrement de référence forme une cavité (144) fermée de manière hermétique pour l'agencement (130) de capteur de référence.

2. Système (100) de capteur de fluide monolithique suivant la revendication 1, dans lequel les éléments de l'agencement (110) de capteur et les éléments de référence de l'agencement (130) de capteur de référence ont la même configuration structurelle.

3. Système (100) de capteur de fluide monolithique suivant la revendication 1 ou 2, comportant en outre :
un substrat (150) de fond, dans lequel une première région (150-1) de surface principale du substrat (150) de fond est liée à la deuxième région (115-2) de surface principale du substrat (115) de capteur, et
un substrat (160) de fond de référence, dans lequel une première région (160-1) de surface principale du substrat (160) de fond de référence est liée à la deuxième région (135-2) de surface principale du substrat (135) de capteur de référence.

4. Système (100) de capteur de fluide monolithique suivant l'une quelconque des revendications précédentes, dans lequel le substrat (115) de capteur et le substrat (135) de capteur de référence sont agencés pour former un substrat (105) de système en commun, dans lequel le substrat (120) de recouvrement et le substrat (140) de recouvrement de référence sont agencés pour former un substrat (145) de recouvrement commun, et dans lequel le substrat (150) de fond et le substrat (160) de fond de référence sont agencés de manière à former un substrat (155) de fond commun.

5. Système (100) de capteur de fluide monolithique suivant l'une quelconque des revendications 1 à 3, dans lequel le substrat (115) de capteur et le substrat (135) de capteur de référence sont agencés pour former des substrats de système distincts, dans lequel le substrat (120) de recouvrement et le substrat (140) de recouvrement de référence sont agencés pour former des substrats de recouvrement distincts, et dans lequel le substrat (150) de fond et le substrat (160) de fond de référence sont agencés pour former des substrats de fond distincts.

6. Système (100) de capteur de fluide monolithique suivant la revendication 1 ou 2, comportant en outre :
un substrat (155) de fond, dans lequel la deuxième région (140-2) de surface principale du substrat (140) de recouvrement de référence est liée à la deuxième région (115-2) de surface principale du substrat (115) de capteur, et dans lequel la première région (155-1) de surface principale du substrat (155) de fond est liée à la deuxième région (135-2) de surface principale du substrat (135) de capteur de référence, de sorte que le substrat (115) de capteur est pris en sandwich entre le substrat (120) de recouvrement et le substrat (140) de recouvrement de référence.

7. Système (100) de capteur de fluide monolithique suivant la revendication 1 ou 2, comportant en outre :
un substrat (155) formant entretoise, dans lequel la première région (155-1) de surface principale du sous-substrat (155) d'entretoise est liée à la deuxième région (115-2) de surface principale du substrat (115) de capteur, et
dans lequel la deuxième région (155-2) de surface principale du substrat (155) formant entretoise est liée à la deuxième région (135-2) de surface principale du substrat (135) de capteur de référence, de sorte que le substrat (155) formant entretoise est pris en sandwich entre le substrat (115) de capteur et le substrat (135) de capteur de référence.

8. Procédé (200) pour fabriquer un système (100) de capteur de fluide monolithique, comportant :
prendre (210) un agencement de capteur ayant un émetteur de rayonnement thermique, une structure de filtre optique, une structure de guide d'ondes et un détecteur de rayonnement thermique sur une première région de surface principale d'un substrat de capteur,
lier (220) une première région de surface principale d'un substrat de recouvrement à la première région de surface principale d'un substrat de capteur, dans lequel le substrat de recouvrement comporte un évidement dans la première région de surface principale et comporte une ouverture traversante entre l'évidement dans la première région de surface principale et une deuxième région de surface principale du substrat de recouvrement,
dans lequel l'évidement forme une cavité et dans lequel l'ouverture traversante forme une connexion pour les fluides de la cavité vers l'environnement,
prendre (230) un agencement de capteur de référence ayant un émetteur de rayonnement thermique de référence, une structure de filtre optique de référence, une structure de guide d'ondes de référence et un détecteur de rayonnement thermique de référence sur une première région de surface principale d'un substrat de capteur de référence, et
lier (240) une première région de surface principale du substrat de recouvrement de référence à la première région de surface principale du substrat de capteur de référence, dans lequel le substrat de recouvrement de référence comporte un évidement de référence dans la première région de surface principale, dans lequel l'évidement de référence dans la première région de surface principale du substrat de recouvrement de référence forme une cavité étanche pour l'agencement de capteur de référence.

9. Procédé (200) suivant la revendication 8, dans lequel les étapes de procédé de prendre (210) un agencement de capteur, de lier (220) une première région de surface principale d'un substrat de recouvrement à la première région de surface principale d'un substrat de capteur, de prendre (230) un agencement de capteur de référence, et de lier (240) une première région de surface principale du substrat de recouvrement de référence à la première région de surface principale du substrat de capteur de référence sont effectuées au niveau de tranche.

10. Procédé (200) suivant la revendication 8 ou 9, comportant en outre :
prendre (250) un substrat de fond et lier une première région de surface principale du substrat de fond à la deuxième région de surface principale du substrat de capteur, et
prendre (260) un substrat de fond de référence et lier (265) une première région de surface principale du substrat de fond de référence à la deuxième région de surface principale du substrat de capteur de référence.

11. Procédé (200) suivant la revendication 10, dans lequel le substrat de capteur et le substrat de capteur de référence sont agencés pour former un substrat de système commun, dans lequel le substrat de recouvrement et le substrat de recouvrement de référence sont agencés pour former un substrat de recouvrement commun, et dans lequel le substrat de fond et le substrat de fond de référence sont agencés pour former un substrat de fond commun, comportant en outre :
conduire (270) au niveau de tranche les étapes de prendre un substrat de fond et lier et les étapes de prendre un substrat de fond de référence et lier.

12. Procédé (200) suivant la revendication 10, dans lequel le substrat de capteur et le substrat de capteur de référence sont agencés pour former des substrats de système distincts, dans lequel le substrat de recouvrement et le substrat de recouvrement de référence sont agencés pour former des substrats de recouvrement distincts, et dans lequel le substrat de fond et le substrat de fond de référence sont agencés pour former des substrats de fond distincts.

13. Procédé (200) suivant la revendication 8 ou 9, comportant en outre :
lier (280) la deuxième région de surface principale du substrat de recouvrement de référence à la deuxième région de surface principale du substrat de capteur, et
prendre (285) un substrat de fond et lier (287) une première région de surface principale du substrat de fond à la deuxième région de surface principale du substrat de capteur de référence.

14. Procédé (200) suivant la revendication 8 ou 9, comportant en outre :
prendre (290) un substrat formant entretoise et lier (295) une première région de surface principale du substrat formant entretoise à la deuxième région de surface principale du substrat de capteur, et lier (297) la deuxième région de surface principale du substrat formant entretoise à la deuxième région de surface principale du substrat formant capteur de référence.

15. Procédé (200) suivant l'une quelconque des revendications 10 à 14, dans lequel les étapes de procédé de lier sont conduites au niveau de tranche au moyen d'une liaison de tranche.
